# EUROPEAN PATENT SPECIFICATION

(11) **EP 3 757 590 B1**
(45) Date of publication and mention of the grant of the patent: **02.08.2023**
(21) Application number: 19901425.9
(22) Date of filing: 12.09.2019
(51) Int. Cl.: G01K 3/00, G01K 7/20, G01K 11/06, G01R 31/392, H01M 10/48, H01M 10/42, H02J 7/00

(54) **THERMAL RUNAWAY DETECTION CIRCUIT**
SCHALTUNG ZUR ERKENNUNG VON THERMISCHEM DURCHGEHEN
CIRCUIT DE DÉTECTION D'EMBALLEMENT THERMIQUE

(30) Priority: 30.04.2019 CN 201920621611 U
(43) Date of publication of application: 30.12.2020
(73) Proprietor: Contemporary Amperex Technology Co., Limited, Jiaocheng District Ningde City Fujian 352100 (CN)
(72) Inventor: XU, Jia, Fujian 352100 (CN); DAN, Zhimin, Fujian 352100 (CN); ZENG, Chao, Fujian 352100 (CN); WANG, Xiao, Fujian 352100 (CN); HOU, Yizhen, Fujian 352100 (CN); ZHANG, Wei, Fujian 352100 (CN); HU, Guoliang, Fujian 352100 (CN)
(74) Representative: Valea AB
(86) International application number: PCT/CN2019/105715
(87) International publication number: WO 2020/220560

(56) References cited:
- EP-A1- 3 734 308
- EP-A1- 3 734 746
- WO-A1-2018/197172
- CN-A- 106 205 029
- CN-A- 107 806 934
- CN-A- 108 288 735
- CN-A- 109 017 363
- CN-A- 109 188 294
- CN-A- 109 494 419
- CN-A- 109 494 419
- CN-U- 207 441 905
- CN-Y- 201 278 018
- DE-A1-102017 214 256
- DE-U1-202017 103 776

## Description

### FIELD

The present application relates to the technical field of batteries, and in particular, to a circuit for detecting thermal runaway.

### BACKGROUND

With the rapid development of new energy, new energy can provide power for more and more equipment. For example, a battery set may be used as a power source to supply power to a new energy vehicle, a new energy ship, a new energy aircraft, and so on. The battery set generates heat during operation. Under normal conditions, the heat generated by the battery set is controllable. However, under abnormal conditions such as collision and overcharge, the heat generated by the battery set is uncontrollable, resulting in thermal runaway. Once thermal runaway occurs, a fire may be caused, thereby threatening the safety of the battery set along with the equipment on which the battery set is installed, and the personal safety of related personnel.

In order to improve the safety of the battery set, currently whether thermal runaway has occurred is determined by monitoring voltage or temperature changes via a battery management system (Battery Management System, BMS). However, in the case of thermal runaway, a circuit board or monitoring unit used to communicate with the BMS may be sputtered and burned by the high temperature electrolyte generated by the thermal runaway. As a result, the BMS cannot detect thermal runaway, which reduces the safety of the battery set.

DE202017103776U1 discloses an automatic warning device for thermal runaway of batteries. The device comprises a plurality of securing elements connected in series, a control circuit and a warning indicator. Each securing element is arranged on the outside of a respective battery cell, and the securing element will be fused when a certain threshold value is reached so that the control circuit may cause the warning indicator to send out a warning signal.

CN 201278018 Y discloses a protection signal acquisition circuit for a battery, which comprises a voltage input end and a grounding terminal. At least a thermal circuit breaker and a divider resistor are connected in series between the voltage input end and the grounding terminal; the thermal circuit breaker is arranged nearby the battery; and a signal output end is connected between the thermal circuit breaker and the divider resistor. When the battery generates heat due to overcharge or overdischarge and other reasons, the thermal circuit breaker is disconnected, the signal output end provides high level signals for a battery protection main circuit, and the battery protection main circuit can further turn off battery charge and discharge circuits to protect the battery.

### SUMMARY

According to the claimed invention, there is provided a circuit for detecting thermal runaway according to claim 1, which may improve the safety of a battery set.

### BRIEF DESCRIPTION OF THE DRAWINGS

The features, advantages, and technical effects of exemplary embodiments of the present application will be described below with reference to the drawings.
Fig. 1 is a schematic structural diagram of a circuit for detecting thermal runaway according to an embodiment of the present application,
Fig. 2 is a schematic structural diagram of a circuit for detecting thermal runaway according to another embodiment of the present application,
Fig. 3 is a schematic structural diagram of a circuit for detecting thermal runaway according to a further embodiment of the present application,
Fig. 4 is a schematic structural diagram of a circuit for detecting thermal runaway according to yet another embodiment of the present application,
Fig. 5 is a schematic structural diagram of a circuit for detecting thermal runaway according to still another embodiment of the present application.

### DETAILED DESCRIPTION

According to an embodiment of the present application, there is provided a circuit for detecting thermal runaway, which may be used in a scenario of performing thermal runaway monitoring on a battery set. The battery set may include at least one single battery cell. The battery set may be a battery module, a battery pack, or the like, which is not limited herein. In an embodiment of the present application, the circuit for detecting thermal runaway can detect the thermal runaway of the battery set in time, which is convenient for taking corresponding measures in a subsequent process, thereby improving the safety of the battery set.

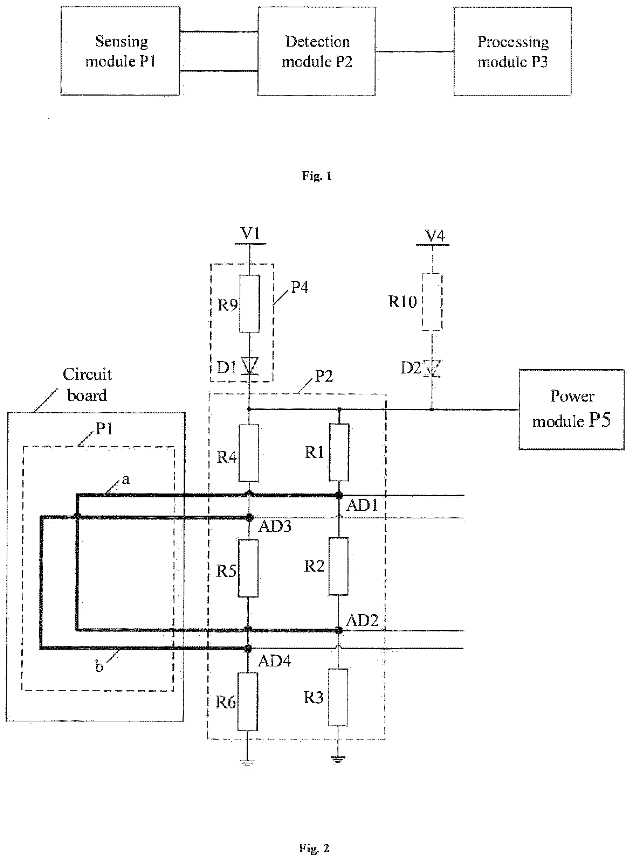

Fig. 1 is a schematic structural diagram of a circuit for detecting thermal runaway according to an embodiment of the present application. As shown, the circuit for detecting thermal runaway may include a sensing module P1, a detection module P2, and a processing module P3.

The sensing module P1 includes a sensing line. A distance between at least a portion of the sensing line and a single battery cell in the battery set is less than a temperature-sensing distance threshold. The number and type of the sensing line may be set according to specific operating scenarios and operating requirements, which is not limited herein.

The temperature-sensing distance threshold may be a distance threshold at which the sensing line can sensitively sense that the temperature of the single battery cell in the battery set is higher than a temperature threshold. In the case that the distance between the sensing line and the single battery cell in the battery set is less than the temperature-sensing distance threshold, an error between a temperature at which the on-off state of the sensing line is caused to change and an actual temperature of the single battery cell in the battery set is within an acceptable range. The temperature-sensing distance threshold may be set according to characteristic parameters of the sensing line and the single battery cell in combination with specific operating scenarios and operating requirements, which is not limited herein.

In some examples, the temperature of the single battery cell is higher than a high temperature threshold, and the on-off state of at least a portion of the sensing line whose distance from the single battery cell is less than the temperature-sensing distance threshold may change, for example, the sensing line may be disconnected. If thermal runaway occurs for the battery set, the temperature of the single battery cell will be higher than the high temperature threshold.

In some examples, in order to detect thermal runaway of the battery set in time, at least a portion of the sensing line may be disposed directly above an explosion-proof valve port of the single battery cell in the battery set. If thermal runaway occurs for the battery set, the explosion-proof valve of the battery cell will rupture, and high-temperature electrolyte, high-temperature gas, etc. will be ejected from the explosion-proof valve port of the battery cell. Disposing at least a portion of the sensing line directly above the explosion-proof valve port of the single battery cell in the battery set can make the sensing line more sensitive to the thermal runaway sensing of the battery set, thereby further improving the accuracy and timeliness of the thermal runaway detection..

Further, the sensing line may pass directly above explosion-proof valve ports of all single battery cells in the battery set. Specific settings for the sensing line may also be determined in conjunction with the internal structure of the battery set. For example, the battery set may be a battery pack, and the battery pack may include a plurality of battery modules. The sensing line may include a plurality of sensing line segments, each sensing line segment may correspond to one or more battery modules, and each sensing line segment may be connected through other wiring harnesses, or connectors, etc.

The detection module P2 may be connected to the sensing line. The detection module P2 may include at least one group of voltage-dividing resistor sets. One end of each group of voltage-dividing resistor sets may be connected to a first power-supply terminal, and the other end of each group of voltage-dividing resistor sets may be connected to the ground. Each group of voltage-dividing resistor sets may include at least two voltage-dividing resistor sets connected in series.

The first power-supply terminal may provide a voltage, for example, a voltage of 5V If the battery set and the circuit for detecting thermal runaway are installed in a battery-powered vehicle, a voltage of 5V at the first power-supply terminal may be provided by a lead-acid battery in the battery-powered vehicle.

A voltage-dividing resistor set may include at least one resistor. If a voltage-dividing resistor set includes multiple resistors, the number and connection method of the resistors are not limited herein. The voltage-dividing resistor set may be used for voltage-dividing, so that the processing module P3 can collect sampled data from a sampling point disposed between two connected voltage-dividing resistor sets.

In some examples, the detection module P2 may be specifically disposed in a Battery Management Unit (Battery Management Unit, BMU). The BMU has a shell structure, and thus the detection module P2 may be prevented from being splashed by the high-temperature electrolyte generated by the battery set for which thermal runaway occurs. Alternatively, the specific setting position of the detection module P2 is not limited, and a protection cover may be provided for the detection module P2 to prevent the detection module P2 from being splashed by the high-temperature electrolyte generated by the battery set for which thermal runaway occurs. Thus, the timeliness of the thermal runaway detection and the safety of the circuit for detecting thermal runaway may be further ensured.

The processing module P3 may be connected to the detection module P2. The processing module P3 may be configured to acquire thermal runaway detection data, and to determine whether thermal runaway has occurred for the battery set based on the thermal runaway detection data.

The thermal runaway detection data may include sampled data collected from a sampling point disposed between two connected voltage-dividing resistor sets.

The data for the battery set may be data related to the battery set, which can characterize various states of the battery set, such as temperature, voltage, fault, and effectiveness of external communication.

The processing module P3 may collect sampled data from the sampling point. The processing module P3 may specifically include a sampling port, and the sampling port may be connected to the sampling point. The position and number of sampling point may be set according to specific operating scenarios and operating requirements, which is not limited herein. The sampled data may include an electrical parameter signal, such as voltage, current, etc., which is not limited herein.

Based on the sampled data collected from the sampling point, the on-off state of the sensing line may be determined, namely, short-circuit, disconnected or normal connection of the sensing line may be determined. The processing module P3 may determine whether thermal runaway has occurred for the battery set based on the on-off state of the sensing line to ensure the reliability of the thermal runaway detection.

In some examples, the processing module P3 may be disposed in the BMU, or the function of the processing module P3 may be integrated in the BMU. For example, the processing module P3 may specifically be a Micro Control Unit (Micro Control Unit, MCU) in the BMU, which is not limited herein.

In an embodiment of the present application, the circuit for detecting thermal runaway may include a sensing module P1, a detection module P2, and a processing module P3. The sensing module P1 may include a sensing line, and a distance between at least a portion of the sensing line and a single battery cell in the battery set is smaller than a temperature-sensing distance threshold, so that the state of the sensing line will be affected by the temperature of the single battery cell in the battery set. Once the sensing line is affected by the temperature of the single battery cell, the on-off state of the sensing line will change, so that the sampled data collected from the sampling point will change. The processing module P3 can detect the thermal runaway of the battery set in time based on the thermal runaway detection data, thereby improving the safety of the battery set.

In some examples, the processing module P3 according to the above embodiment may further include an alarm circuit configured to send an alarm signal to a vehicle controller if it is determined that thermal runaway occurs for the battery set, so as to trigger the vehicle controller to take corresponding measures or prompt relevant personnel.

In an embodiment of the present application, if the circuit for detecting thermal runaway is installed in a battery-powered vehicle, thermal runaway detection and alarm can still be performed when the entire vehicle of the battery-powered vehicle is in a parking and sleep state.

Several specific structures of the circuit for detecting thermal runaway will be described below.

Fig. 2 is a schematic structural diagram of a circuit for detecting thermal runaway according to another embodiment of the present application (the processing module P3 is not shown). As shown in Fig. 2, the sensing line in the detection module P2 may include a first sensing line and a second sensing line. The detection module P2 may include two groups of voltage-dividing resistor sets.

The first sensing line and the second sensing line may be specifically disposed on a circuit board above the battery set. For example, the circuit board may be a Flexible Printed Circuit (Flexible Printed Circuit, FPC), and the first sensing line and the second sensing line may be copper wires coated in a substrate of the FPC to distinguish from a sampling line for acquiring a temperature, voltage, etc. originally disposed on the FPC. The first sensing line and the second sensing line may be thinner than the sampling line, that is, the diameter of the first sensing line and the second sensing line may be smaller than the diameter of the sampling line.

At least a portion of the first sensing line and at least a portion of the second sensing line may be located directly above an explosion-proof valve port of a single battery cell in the battery set. If thermal runaway occurs for the battery set, the explosion-proof valve of the battery cell will rupture, and high-temperature electrolyte, high-temperature gas, etc. will be ejected from the explosion-proof valve port of the battery cell. Disposing the at least a portion of the first sensing line and the at least a portion of the second sensing line directly above the explosion-proof valve port of the single battery cell in the battery set can make the first sensing line and the second sensing line more sensitive to thermal runaway sensing of the battery set, thereby further improving the accuracy and timeliness of the thermal runaway detection.

Further, the first sensing line and the second sensing line may pass directly above explosion-proof valve ports of all single battery cells in the battery set. Specific settings for the first sensing line and the second sensing line may also be determined in combination with the internal structure of the battery set. For example, the battery set may be a battery pack including a plurality of battery modules, and a plurality of circuit boards may be disposed in the battery pack. The first sensing line may include a plurality of sensing line segments, each sensing line segment may be disposed on a circuit board, and each sensing line segment may be connected through other wiring harnesses, plug-in components, etc. Settings for the second sensing line may refer to those for the first sensing line, and details will not be described herein again.

In an embodiment of the present application, the sampling point may include a first sampling point, a second sampling point, a third sampling point, and a fourth sampling point.

The first group of voltage-dividing resistor sets may include a first voltage-dividing resistor set, a second voltage-dividing resistor set, and a third voltage-dividing resistor set connected in series. One end of the first voltage-dividing resistor set may be connected to the first power-supply terminal. One end of the third voltage-dividing resistor set may be connected to the ground.

For example, as shown in Fig. 2, the first voltage-dividing resistor set includes a resistor R1, the second voltage-dividing resistor set includes a resistor R2, and the third voltage-dividing resistor set includes a resistor R3. One end of the resistor R1 is connected to the first power-supply terminal V1, and the other end of the resistor R1 is connected to one end of the resistor R2. The other end of the resistor R2 is connected to one end of the resistor R3. The other end of the resistor R3 is connected to the ground.

The first sampling point may be disposed between the first voltage-dividing resistor set and the second voltage-dividing resistor set. The second sampling point may be disposed between the second voltage-dividing resistor set and the third voltage-dividing resistor set. One end of the first sensing line may be connected to the first sampling point, and the other end of the first sensing line may be connected to the second sampling point.

For example, as shown in Fig. 2, the first sampling point is labeled as AD1, and the second sampling point is labeled as AD2. The first sampling point AD1 is disposed between the resistor R1 and the resistor R2, and the second sampling point AD2 is disposed between the resistor R2 and the resistor R3. The first sensing line is marked with "a", and the first sensing line is equivalent to being connected in parallel with the resistor R2.

The second group of voltage-dividing resistor sets may include a fourth voltage-dividing resistor set, a fifth voltage-dividing resistor set, and a sixth voltage-dividing resistor set connected in series. One end of the fourth voltage-dividing resistor set may be connected to the first power-supply terminal. One end of the sixth voltage-dividing resistor set may be connected to the ground.

For example, as shown in Fig. 2, the fourth voltage-dividing resistor set includes a resistor R4, the fifth voltage-dividing resistor set includes a resistor R5, and the sixth voltage-dividing resistor set includes a resistor R6. One end of the resistor R4 is connected to the first power-supply terminal V1, and the other end of the resistor R4 is connected to one end of the resistor R5. The other end of the resistor R5 is connected to one end of the resistor R6. The other end of the resistor R6 is connected to the ground.

The third sampling point may be disposed between the fourth voltage-dividing resistor set and the fifth voltage-dividing resistor set. The fourth sampling point may be disposed between the fifth voltage-dividing resistor set and the sixth voltage-dividing resistor set. One end of the second sensing line may be connected to the third sampling point, and the other end of the second sensing line may be connected to the fourth sampling point.

For example, as shown in Fig. 2, the third sampling point is labeled as AD3, and the fourth sampling point is labeled as AD4. The third sampling point AD3 is disposed between the resistor R4 and the resistor R5, and the fourth sampling point AD4 is disposed between the resistor R5 and the resistor R6. The second sensing line is marked with "b", and the second sensing line "b" is equivalent to being connected in parallel with the resistor R5.

If the first sensing line "a" is not disconnected, the circuit where the first power-supply terminal V1 is connected to the ground through the first voltage-dividing resistor set is: the first power-supply terminal V1 → the resistor R1 → the first sensing line "a" → the resistor R3 → the ground.

If the first sensing line "a" is disconnected, the circuit where the first power-supply terminal V1 is connected to the ground through the first voltage-dividing resistor set: the first power-supply terminal V1 → the resistor R1 → the resistor R2 → the resistor R3 → the ground.

Similarly, if the second sensing line "b" is not disconnected, the circuit where the first power-supply terminal V1 is connected to the ground through the second voltage-dividing resistor set is: the first power-supply terminal V1 → the resistor R4 → the second sensing line "b" → the resistor R6 → the ground.

If the second sensing line "b" is disconnected, the circuit where the first power-supply terminal V1 is connected to the ground through the second voltage-dividing resistor is: the first power-supply terminal V1 → the resistor R4 → the resistor R5 → the resistor R6 → the ground.

Therefore, under two cases of the first sensing line "a" being disconnected and not being disconnected, the first sampled data collected from the first sampling point AD 1 and the second sampled data collected from the second sampling point AD2 are different. The on-off state of the first sensing line "a" may be determined based on the first sampled data and the second sampled data. The on-off state may include "disconnected" and "not disconnected" (i.e., normal connection).

Similarly, under two cases of the second sensing line "b" being disconnected and not being disconnected, the third sampled data collected from the third sampling point AD3 and the fourth sampled data collected from the fourth sampling point AD4 are different. The on-off state of the second sensing line "b" may be determined based on the third sampled data and the fourth sampled data. The on-off state may include "disconnected" and "not disconnected" (i.e., normal connection).

In some examples, the thermal runaway detection data may further include the data for the battery set.

In some examples, a first disconnection threshold range and a second disconnection threshold range for determining whether the first sensing line is disconnected, and a third disconnection threshold range and a fourth disconnection range for determining whether the second sensing line is disconnected may be set in advance.

In some examples, a first connection threshold range and a second connection threshold range for determining whether the first sensing line is in normal connection, and a third connection threshold range and a fourth disconnection range for determining whether the second sensing line is in normal connection may also be set in advance.

The first disconnection threshold range and the second disconnection threshold range may be related to a voltage provided by the first power-supply terminal, the first voltage-dividing resistor set, the second voltage-dividing resistor set, the third voltage-dividing resistor set, and an acceptable error range. That is to say, the first disconnection threshold range and the second disconnection threshold range may be calculated based on the voltage provided by the first power-supply terminal, the first voltage-dividing resistor set, the second voltage-dividing resistor set, the third voltage-dividing resistor set, and the acceptable error range.

The third disconnection threshold range and the fourth disconnection threshold range may be related to the voltage provided by the first power-supply terminal, the fourth voltage-dividing resistor set, the fifth voltage-dividing resistor set, the sixth voltage-dividing resistor set, and an acceptable error range. That is to say, the third disconnection threshold range and the fourth disconnection threshold range may be calculated based on the voltage provided by the first power-supply terminal, the fourth voltage-dividing resistor set, the fifth voltage-dividing resistor set, the sixth voltage-dividing resistor set, and the acceptable error range.

The first connection threshold range and the second connection threshold range may be related to the voltage provided by the first power-supply terminal, the first voltage-dividing resistor set, the third voltage-dividing resistor set, and an acceptable error range. That is to say, the first connection threshold range and the second connection threshold range may be calculated based on the voltage provided by the first power-supply terminal, the first voltage-dividing resistor set, the third voltage-dividing resistor set, and the acceptable error range.

The third connection threshold range and the fourth connection threshold range may be related to the voltage provided by the first power-supply terminal, the fourth voltage-dividing resistor set, the sixth voltage-dividing resistor set, and an acceptable error range. That is to say, the third connection threshold range and the fourth connection threshold range may be calculated based on the voltage provided by the first power-supply terminal, the fourth voltage-dividing resistor set, the sixth voltage-dividing resistor set, and the acceptable error range.

It should be noted that the first connection threshold range and the second connection threshold range may be the same, or the deviation between the first connection threshold range and the second connection threshold range is within an acceptable range. The third connection threshold range and the fourth connection threshold range may be the same, or the deviation between the third connection threshold range and the fourth connection threshold range is within an acceptable range.

The processing module P3 may include a sampling port, a sensor, a first comparison circuit, a second comparison circuit, and a first determination circuit.

The sampling ports may be connected to the first sampling point, the second sampling point, the third sampling point, and the fourth sampling point to acquire first sampled data, second sampled data, third sampled data, and fourth sampled data from the first sampling point, the second sampling point, the third sampling point, and the fourth sampling point, respectively. Specifically, for each sampling point, one sampling port may be set correspondingly, and the sampled data corresponding to the sampling point may be collected through the sampling port.

The sensor may be configured to collect the data for the battery set. In particular, the sensor may be a voltage sensor, a temperature sensor, a communication sensor, or the like, which is not limited herein.

The first comparison circuit may be connected to the sampling ports, and may be configured to send a first disconnection signal if the first sampled data is within the first disconnection threshold range and the second sampled data is within the second disconnection threshold range. The first disconnection signal may indicate that the first sensing line is disconnected.

The second comparison circuit may be connected to the sampling ports, and may be configured to send a second disconnection signal if the third sampled data is within the third disconnection threshold range and the fourth sampled data is within the fourth disconnection threshold range. The second disconnection signal may indicate that the second sensing line is disconnected.

The first determination circuit may be connected to the first comparison circuit, the second comparison circuit, and the sensor. The first determination circuit may be configured to determine that thermal runaway occurs for the battery set if within a preset time period, the first disconnection signal and the second disconnection signal are received, and at least one parameter in the data for the battery set meets a fault condition.

The first comparison circuit, the second comparison circuit, and the first determination circuit may include a component such as a resistor, a capacitor, a comparator, an amplifier, etc., which is not limited herein.

The data for the battery set may include at least one parameter. The parameter may be used to characterize various states of the battery set, such as temperature, voltage, fault, and effectiveness of external communication.

In some examples, the data for the battery set may specifically be various types of parameters related to the battery set. For example, the parameters may be one or more of a maximum temperature of a single battery cell in the battery set, a temperature change rate of a single battery cell in the battery set, a difference between the maximum temperature and a minimum temperature of a single battery cell in the battery set, and a minimum voltage of a single battery cell in the battery set, the number of disconnection faults of voltage sampling of the battery set, a temperature-sensing fault parameter, and a communication fault parameter for monitoring of a battery cell, which is not limited herein.

The fault condition may include: a parameter exceeds a safety threshold range of the parameter, or a parameter indicates a fault. The preset time period may be set according to specific operating scenarios and operating requirements, which is not limited herein. Setting the preset time period can effectively avoid at least a portion of misjudgements for thermal runaway, thereby improving the reliability of thermal runaway detection.

Corresponding to each parameter in the data for the battery set, there are different safety parameter threshold ranges. For example, a safety parameter threshold range corresponding to the maximum temperature of a single battery cell in the battery set may specifically be a safety threshold range of the maximum temperature. A safety parameter threshold range corresponding to the temperature change rate of a single battery cell in the battery set may specifically be a safety threshold range of the temperature change rate. A safety parameter threshold range corresponding to the difference between the maximum temperature and the minimum temperature of a single battery cell in the battery set may specifically be a safety threshold range of the temperature difference. A safety parameter threshold range corresponding to the minimum voltage of a single battery cell in the battery set may be specifically a safety threshold range of the minimum voltage. A safety parameter threshold range corresponding to the number of disconnection faults for sampling a voltage of the battery set may specifically be a safety threshold range of fault data.

The temperature-sensing fault parameter may indicate whether a sensor or sensing component used for temperature measurement has failed. For example, a Negative Temperature Coefficient (Negative Temperature Coefficient, NTC) thermistor may be disposed in the battery set, and the temperature-sensing fault parameter may indicate whether the NTC thermistor disposed in the battery set has completely failed.

The communication fault parameter for monitoring of a battery cell may indicate whether a communication between a component for monitoring a single battery cell and the BMU has failed (that is, whether it is lost). For example, a single battery cell in the battery set may be configured with a Cell Supervision Circuit (CSC), and the communication fault parameter for monitoring of a battery cell may indicate whether the communication between the CSC and the BMU has failed.

For example, the following are several examples of determining that thermal runaway occurs for the battery set when it is determined that the first sensing line and the second sensing line are disconnected. However, it should be noted that the cases in which it is determined that thermal runaway occurs for the battery set include, but are not limited to, the following examples.

Example 1: within 10 minutes, it is determined that the first sensing line and the second sensing line are disconnected, and the maximum temperature of a single battery cell in the battery set is greater than 68.4 °C for 2 seconds, then it may be determined that thermal runaway occurs for the battery set.

Example 2: within 10 minutes, it is determined that the first sensing line and the second sensing line are disconnected, and the temperature change rate of a single battery cell in the battery set is greater than 3 °C/sec for 2 seconds, then it may be determined that thermal runaway occurs for the battery set.

Example 3: within 10 minutes, it is determined that the first sensing line and the second sensing line are disconnected, and the difference between the maximum temperature and the minimum temperature of a single battery cell in the battery set is greater than 30 °C, then it may be determined that thermal runaway occurs for the battery set.

Example 4: within 10 minutes, it is determined that the first sensing line and the second sensing line are disconnected, and the minimum voltage of a single battery cell in the battery set is less than 2V for 300 milliseconds, then it may be determined that thermal runaway occurs for the battery set.

Example 5: within 10 minutes, it is determined that the first sensing line and the second sensing line are disconnected, and the number of disconnection faults for sampling a voltage of the battery set is greater than or equal to 1, then it may be determined that thermal runaway occurs for the battery set.

Example 6: within 10 minutes, it is determined that the first sensing line and the second sensing line are disconnected, and the temperature-sensing fault parameter may indicate that the NTC thermistor disposed in the battery set has completely failed, then it may be determined that thermal runaway occurs for the battery set.

Example 7: within 10 minutes, it is determined that the first sensing line and the second sensing line are disconnected, and the communication fault parameter for monitoring of a battery cell may indicate the communication between the CSC and the BMU has failed, then it may be determined that thermal runaway occurs for the battery set.

In other examples, the first determining circuit may further be configured to determine that thermal runaway occurs for the battery set if within a preset time period, the first disconnection signal and/or the second disconnection signal are not received, and at least one group of parameters in the data for the battery set meets the fault condition.

Failing to receive the first disconnection signal and/or the second disconnection signal may indicate that at least one of the first sensing line and the second sensing line is not disconnected. Specifically, only one of the first sensing line and the second sensing line is disconnected, or specifically, neither the first sensing line nor the second sensing line is disconnected.

A group of parameters may include at least two parameters. A group of parameters may include, but are not limited to, any of the following groups of parameters:
The first group: the minimum voltage of a single battery cell in the battery set and the maximum temperature of a single battery cell in the battery set.
The second group: the minimum voltage of a single battery cell in the battery set and the temperature change rate of a single battery cell in the battery set.
The third group: the minimum voltage of a single battery cell in the battery set and the difference between the maximum temperature and the minimum temperature of a single battery cell in the battery set.
The fourth group: the temperature change rate of a single battery cell in the battery set and the maximum temperature of a single battery cell in the battery set.
The fifth group: the temperature change rate of a single battery cell in the battery set and the difference between the maximum temperature and the minimum temperature of a single battery cell in the battery set.
The sixth group: the number of disconnection faults for sampling a voltage of the battery set and the maximum temperature of the single battery cell in the battery set.
The seventh group: the number of disconnection faults of voltage sampling of the battery set and the temperature change rate of a single battery cell in the battery set.
The eighth group: the number of disconnection faults of voltage sampling of the battery set and the difference between the maximum temperature and the minimum temperature of a single battery cell in the battery set.
The ninth group: the number of disconnection faults of voltage sampling of the battery set and the temperature-sensing fault parameter.

Specific parameters and related contents of each of the foregoing groups of parameters may refer to related descriptions in the above embodiments, and details will not be described herein again. The fault condition may include: a parameter exceeds a safety threshold range of the parameter or a parameter indicates a fault.

For example, multiple groups of parameters and their corresponding fault conditions are listed below as an example. If at least one group of parameters meets its own corresponding fault condition, then it may be determined that thermal runaway occurs for the battery set. At least two parameters meet their own corresponding fault conditions can further improve the reliability of thermal runaway detection. It should be noted that the parameters and fault conditions according to the embodiments of the present application may include, but are not limited to, the following parameters and fault conditions.

The first group of parameters and its fault condition: the minimum voltage of a single battery cell in the battery set is less than 2V for 300 milliseconds, and the maximum temperature of a single battery cell in the battery set is greater than 68 ° C for 2 seconds.

The second group of parameters and its fault condition: the minimum voltage of a single battery cell in the battery set is less than 2V for 300 milliseconds, and the temperature change rate of a single battery cell in the battery set is greater than 3 °C/sec for 2 seconds.

The third group of parameters and its fault condition: the minimum voltage of a single battery cell in the battery set is less than 2V for 300 milliseconds, and the difference between the maximum temperature and the minimum temperature of a single battery cell in the battery set is greater than 30 °C.

The fourth group of parameters and its fault condition: the temperature change rate of a single battery cell in the battery set is greater than 3 °C/sec for 2 seconds, and the maximum temperature of a single battery cell in the battery set is greater than 68 °C for 2 seconds.

The fifth group of parameters and its fault condition: the temperature change rate of a single battery cell in the battery set is greater than 3 °C/sec for 2 seconds, and the difference between the maximum temperature and the minimum temperature of a single battery cell in the battery set is greater than 30 °C.

The sixth group of parameters and its fault condition: the number of disconnection faults for sampling a voltage of the battery set is greater than or equal to 1, and the maximum temperature of a single battery cell in the battery set is greater than 68 °C for 2 seconds.

The seventh group of parameters and its fault condition: the number of disconnection faults for sampling a voltage of the battery set is greater than or equal to 1, and the temperature change rate of a single battery cell in the battery set is greater than 3 °C/sec for 2 seconds.

The eighth group of parameters and its fault condition: the number of disconnection faults for sampling a voltage of the battery set is greater than or equal to 1, and the difference between the maximum temperature and the minimum temperature of a single battery cell in the battery set is greater than 30 °C.

The ninth group of parameters and its fault condition: the number of disconnection faults for sampling a voltage of the battery set is greater than or equal to 1, and the temperature-sensing fault parameter indicates that the NTC thermistor disposed in the battery set has completely failed.

If at least one of the above nine groups of parameters meets the fault condition corresponding to the group of parameters, then it may be determined that thermal runaway occurs for the battery set.

In another example, if it is determined that only one of the first sensing line and the second sensing line is disconnected, then it may also be determined that no fault occurs for the battery set, and no fault processing will be performed.

It should be noted that if the first sampled data is neither within the first disconnection threshold range nor within the first connection threshold range, it may be determined that a sampling port corresponding to the first sampling point has failed. If the second sampled data is neither within the second disconnection threshold range nor within the second connection threshold range, it may be determined that a sampling port corresponding to the second sampling point has failed. If the third sampled data is neither within the third disconnection threshold range nor within the third connection threshold range, it may be determined that a sampling port corresponding to the third sampling point has failed. If the fourth sampled data is neither within the fourth disconnection threshold range nor within the fourth connection threshold range, it may be determined that a sampling port corresponding to the fourth sampling point has failed.

If it is determined that a sampling port corresponding to a sampling point has failed, a prompt message for a sampling fault may be sent to prompt the vehicle controller to take corresponding measures or prompt relevant personnel.

In some examples, the first determination circuit is further configured to send a thermal runaway warning message, if the first disconnection signal and/or the second disconnection signal are not received, and the data for the battery set meets the fault condition,.

The data for the battery set may include a maximum voltage of the single battery cell in the battery set during charging, an actual state of charge of the battery set during charging, and a charging current of the battery set during charging. The fault condition may include: a parameter exceeds a safety threshold range of the parameter.

Corresponding to specific parameters in the data for the battery set, the safety parameter threshold ranges may include a safety parameter threshold range of a voltage, a safety parameter threshold range of state of charge, and a safety parameter threshold range of a current.

That is to say, if it is determined that at least one of the first sensing line and the second sensing line is not disconnected, the maximum voltage of the single battery cell in the battery set during charging exceeds the safety parameter threshold range of a voltage, the actual state of charge of the battery set during charging exceeds the safety parameter threshold range of state of charge, and the charging current of the battery set during charging exceeds the safety parameter threshold range of a current, then it may be predicted that thermal runaway will occur for the battery set. A thermal runaway warning message may be sent, thereby taking corresponding measures in advance to avoid thermal runaway and to further improve the safety of the battery set.

For example, during charging, if the maximum voltage of the single battery cell in the battery set is greater than 1.1 times a three-level overvoltage threshold, the actual state of charge of the battery set is greater than 115%, and the charging current is greater than or equal to 0.33 times an 1-hour rated charging current, then it may be predicted that thermal runaway is about to occur, and a thermal runaway warning message may be sent.

In some embodiments, the states of the BMU may include an operating state and a sleep state. When the BMU is in the operating state, a power module P5 of the BMU may control a power-supply module of the BMU to be powered on, causing that the BMU is in the operating state and can normally perform data monitoring of the battery set, such as voltage monitoring, current monitoring, temperature monitoring, insulation monitoring, and state of charge monitoring, etc., to acquire a voltage, current, temperature, state of charge, etc. as the thermal runaway detection data. When the BMU is in the sleep state, the power module P5 of the BMU may control the power-supply module of the BMU to power off, then the BMU stops the data monitoring of the battery set. The power module P5 may be implemented as a power chip, such as a System Basis Chip (SBC), which is not limited herein.

If thermal runaway occurs for the battery set while the BMU is in the sleep state, the BMU stops the data monitoring of the battery set and cannot provide the thermal runaway detection data. If the processing module P3 is integrated in the BMU, and the BMU is in a sleep state, it is also impossible to detect and determine thermal runaway.

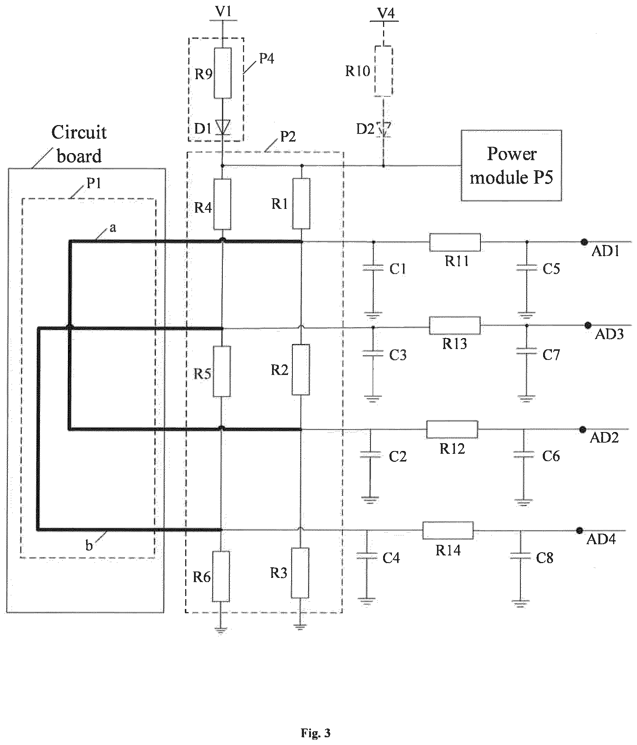

In order to perform thermal runaway detection and acquire the thermal runaway detection data during the process of thermal runaway detection while the BMU in the sleep state, Fig. 3 shows a schematic structural diagram of a circuit for detecting thermal runaway according to a further embodiment of the present application (the processing module P3 is not shown). A sleep/wake-up module P4 shown in Fig. 2 and Fig. 3 can wake up the BMU when the BMU is in the sleep state and thermal runaway may occur. The difference between Fig. 3 and Fig. 2 is that the detection module P2 in the circuit for detecting thermal runaway shown in Fig. 3 may further include some protection devices and/or filtering devices. The protection devices may specifically include protection capacitors, and the filter devices may specifically include a filter capacitor and a filter resistor.

The sleep/wake-up module P4 may be disposed between the first power-supply terminal and all groups of voltage-dividing resistor sets. The sleep/wake-up module P4 may be configured to send a control signal to the power module P5 of the battery management unit when the battery management unit is in the sleep state.

The control signal is to instruct the power module P5 to control the battery management unit to remain in the sleep state or switch to the operating state. For example, if a voltage of the control signal is higher than or equal to a startup voltage threshold of the power module P5, that is, the control signal controls the BMU to switch to the operating state, then the BMU is woken up. If the voltage of the control signal is lower than the startup voltage threshold of the power module P5, that is, the control signal controls the BMU to remain in the sleep state, then the BMU is not woken up.

In some examples, the sleep/wake-up module P4 may include a ninth voltage-dividing resistor set. Alternatively, the sleep/wake-up module P4 may include the ninth voltage-dividing resistor set and a diode. The diode may be disposed between the ninth voltage-dividing resistor set and the power module P5. Specifically, an anode of the diode may be connected to the ninth voltage-dividing resistor set, and a cathode of the diode may be connected to the power module P5.

For example, as shown in Fig. 3, the sleep/wake-up module P4 may include a ninth voltage-dividing resistor set and a diode. The ninth voltage-dividing resistor set may include a resistor R9. One end of the resistor R9 may be connected to the first power-supply terminal V1, and the other end of the resistor R9 may be connected to the anode of the diode D1. The cathode of the diode D1 may be connected to the power module, one end of the resistor R1, and one end of the resistor R4.

It should be noted that if the BMU is in the operating state, a fourth power-supply terminal may continuously provide a wake-up signal to the power module P5 of the BMU. The fourth power-supply terminal may be powered on when the BMU is in the operating state, so as to ensure that the wake-up signal may be continuously provided to the BMU. The fourth power-supply terminal may be powered off when the BMU is in the sleep state, and the BMU may be woken up by the sleep/wake-up module P4. As shown in Fig. 3, a resistor R10 may be disposed between the fourth power-supply terminal V4 and the BMU. A diode D2 may also be disposed between the resistor R10 and the power module P5. An anode of the diode D2 may be connected to the resistor R10, and a cathode of the diode D2 may be connected to the power module P5. Both diodes D1 and D2 can prevent a current from flowing backward. The diode D 1 and the diode D2 may also compete for supplying power. For example, if a voltage provided by the fourth power-supply terminal V4 is higher than a voltage provided by the first power-supply terminal V1, when the BMU is in the operating state, the fourth power-supply terminal V4 can ensure that the BMU is continuously in the operating state.

A value of the voltage provided by the fourth power-supply terminal V4 and a value of the voltage provided by the first power-supply terminal V1 may be the same or different, which is not limited herein. For example, the voltage provided by the fourth power-supply terminal V4 may be 12V

One end of a protection capacitor may be connected to one end of a voltage-dividing resistor set that a sampling point is connected to, and the other end of the protection capacitor may be connected to the ground. The protection capacitor can prevent the occurrence of Electro Static Discharge (ESD) in the circuit for detecting thermal runaway.

If the sampling point includes a first sampling point, a second sampling point, a third sampling point, and a fourth sampling point. Correspondingly, the protection capacitors may include a first protection capacitor, a second protection capacitor, a third protection capacitor, and a fourth protection capacitor. As shown in Fig. 3, one end of the first protection capacitor C1 is connected to one end of the resistor R1 that the first sampling point AD1 is connected to, one end of the second protection capacitor C2 is connected to one end of the resistor R2 that the second sampling point AD2 is connected to, and one end of the third protection capacitor C3 is connected to one end of the resistor R4 that the third sampling point AD3 is connected to, and one end of the fourth protection capacitor C4 is connected to one end of the resistor R5 that the fourth sampling point AD4 is connected to. The other ends of the first protection capacitor C1, the second protection capacitor C2, the third protection capacitor C3, and the fourth protection capacitor C4 are connected to the ground.

The detection module P2 may further include a filter capacitor and a filter resistor. One end of the filter capacitor may be connected to one end of the filter resistor and a sampling point, and the other end of the filter capacitor may be connected to the ground. The other end of the filter resistor may be connected to one end of a protection capacitor.

If the sampling point includes a first sampling point, a second sampling point, a third sampling point, and a fourth sampling point. Correspondingly, the filter capacitor may include a first filter capacitor C5, a second filter capacitor C6, a third filter capacitor C7, and a fourth filter capacitor C8. The filter resistor may include a resistor R11, a resistor R12, a resistor R13, and a resistor R14. As shown in Fig. 3, one end of the first filter capacitor C5 is connected to one end of the resistor R11, and the other end of the first filter capacitor C5 is connected to the ground. One end of the second filter capacitor C6 is connected to one end of the resistor R12, and the other end of the second filter capacitor C6 is connected to the ground. One end of the third filter capacitor C7 is connected to one end of the resistor R13, and the other end of the third filter capacitor C7 is connected to the ground. One end of the fourth filter capacitor C8 is connected to one end of the resistor R13, and the other end of the fourth filter capacitor C8 is connected to the ground. The other end of the resistor R11 is connected to the first sampling point AD1. The other end of the resistor R12 is connected to the second sampling point AD2. The other end of the resistor R13 is connected to the third sampling point AD3. The other end of the resistor R14 is connected to the fourth sampling point AD4.

The filter capacitor and the filter resistor may form an RC filter circuit, which can filter the sampled data of the sampling point to improve the accuracy of the sampled data collected from the sampling point, thereby improving the accuracy of the thermal runaway detection.

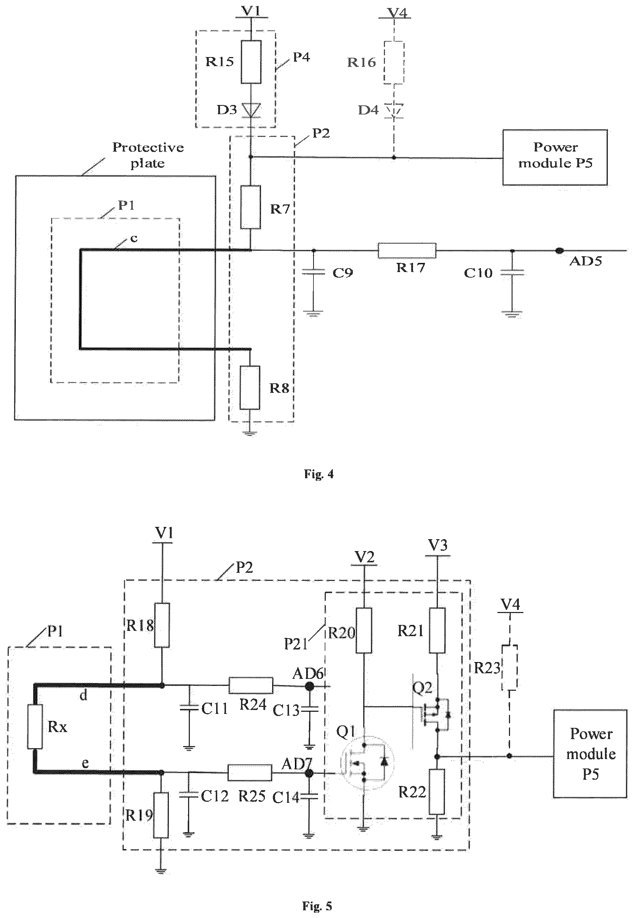

Fig. 4 is a schematic structural diagram of a circuit for detecting thermal runaway according to yet another embodiment of the present application (the processing module P3 is not shown). As shown in Fig. 4, the sensing line in the sensing module P1 may include a third sensing line. The detection module P2 may include a group of voltage-dividing resistor sets.

The third sensing line may be disposed in a protective plate above the battery set. In some examples, the third sensing line may be a tin wire or other connecting wires made of other materials that are conductive and have a melting point below a melting point threshold. The melting point threshold may be set according to specific operating scenarios and operating requirements, which is not limited herein. The protection board may be a mica plate, and the third sensing line, such as a tin wire, may be buried in the mica plate.

At least a portion of the third sensing line may be located directly above the explosion-proof valve port of the single battery cell in the battery set. If thermal runaway occurs for the battery set, the explosion-proof valve of the battery cell will rupture, and high-temperature electrolyte, high-temperature gas, etc. will be ejected from the explosion-proof valve port of the battery cell. Disposing at least a portion of the third sensing line directly above the explosion-proof valve port of the single battery cell in the battery set can make the third sensing line more sensitive to the thermal runaway sensing of the battery set, thereby further improving the accuracy and timeliness of the thermal runaway detection.

Further, the third sensing line may pass directly above explosion-proof valve ports of all single battery cells in the battery set. Specific settings for the third sensing line may also be determined in combination with the internal structure of the battery set. For example, the battery set may be a battery pack including a plurality of battery modules, and a plurality of protective plates may be disposed in the battery set. For example, the third sensing line may include a plurality of sensing line segments, each sensing line segment may be disposed in a protective plate, and each sensing line segment may be connected through other wiring harnesses, or connectors, etc.

In an embodiment of the present application, the sampling point may include a fifth sampling point.

The group of voltage-dividing resistor sets may include a seventh voltage-dividing resistor set and an eighth voltage-dividing resistor set. The seventh voltage-dividing resistor set and the eighth voltage-dividing resistor may be connected in series through the third sensing line. One end of the seventh voltage-dividing resistor set may be connected to the first power-supply terminal, the other end of the seventh voltage-dividing resistor set may be connected to the other end of the eighth voltage-dividing resistor set through a third sensing line, and one end of the eighth voltage-dividing resistor set may be connected to the ground. The fifth sampling point may be disposed between the seventh voltage-dividing resistor set and the eighth voltage-dividing resistor set.

In some embodiments, the circuit for detecting thermal runaway may further include a sleep/wake-up module P4. The connection position and function of the sleep/wake-up module P4 are basically the same as the sleep/wake-up module P4 in the above embodiments, and thus reference may be made to related description section in the above embodiments, and details will not be described herein again.

For example, as shown in Fig. 4, the seventh voltage-dividing resistor set may include a resistor R7, and the eighth voltage-dividing resistor set may include a resistor R8. A ninth voltage-dividing resistor set in the sleep/wake-up module P4 may include a resistor R15. The sleep/wake-up module P4 may further include a diode D3. One end of the resistor R15 may be connected to the first power-supply terminal V1, and the other end of the resistor R15 may be connected to an anode of the diode D3. A cathode of the diode D3 may be connected to one end of the resistor R7. The other end of the resistor R7 may be connected to the other end of the resistor R8 through a third sensing line "c". One end of the resistor R8 may be connected to the ground.

It is worth mentioning that if the circuit for detecting thermal runaway includes a sleep/wake-up module P4, the sleep/wake-up module P4 includes a ninth voltage-dividing resistor set. The first disconnection threshold range, the second disconnection threshold range, the third disconnection threshold range, the fourth disconnection threshold range, the first connection threshold range, the second connection threshold range, the third connection threshold range and the fourth connection threshold range in the above embodiments may also be related to the ninth voltage-dividing resistor set. If the sleep/wake-up module P4 further includes a diode, then the first disconnection threshold range, the second disconnection threshold range, the third disconnection threshold range, the fourth disconnection threshold range, the first connection threshold range, the second connection threshold range, the third connection threshold range and the fourth connection threshold range in the above embodiments may also be related to the diode.

In some examples, if the voltage provided by the fourth power-supply terminal is higher than the voltage provided by the first power-supply terminal, the first disconnection threshold range, the second disconnection threshold range, the third disconnection threshold range, the fourth disconnection threshold range, the first connection threshold range, the second connection threshold range, the third connection threshold range and the fourth connection threshold range in the above embodiments may also be related to the resistor and diode between the fourth power-supply terminal and the power module P5.

It should be noted that if the BMU is in the operating state, a fourth power-supply terminal may continuously provide a wake-up signal to the power module P5 of the BMU. The fourth power-supply terminal may be powered on when the BMU is in the operating state, so as to ensure that the wake-up signal may be continuously provided to the BMU. The fourth power-supply terminal may be powered off when the BMU is in the sleep state, and the BMU may be woken up by the sleep/wake-up module P4. As shown in Fig. 4, a resistor R16 may be disposed between the fourth power-supply terminal V4 and the BMU. A diode D4 may also be disposed between the resistor R16 and the power module P5. An anode of the diode D4 may be connected to the resistor R16, and a cathode of the diode D4 may be connected to the power module P5. Both diodes D3 and D4 can prevent a current from flowing backward. The diode D3 and the diode D4 may also compete for supplying power. For example, if a voltage provided by the fourth power-supply terminal V4 is higher than a voltage provided by the first power-supply terminal V1, when the BMU is in the operating state, the fourth power-supply terminal V4 can ensure that the BMU is continuously in the operating state.

In some examples, the detection module P2 may further include some protection devices and/or filtering devices, such as a protection capacitor, a filter capacitor, and a filter resistor. Related contents of the protection capacitor, the filter capacitor, and the filter resistor may refer to related descriptions in the above embodiments, and details will not be described herein again.

For example, as shown in Fig. 4, the protection capacitor in the detection module P2 may include a fifth protection capacitor C9. The filter capacitor may include a fifth filter capacitor C10. The filter resistor may include a resistor R17. One end of the fifth protection capacitor C9 may be connected to one end of the resistor R7 that the fifth sampling point AD5 is connected to, and the other end of the fifth protection capacitor C9 is connected to the ground. One end of the fifth filter capacitor C10 is connected to one end of the resistor R17 and the fifth sampling point AD5, and the other end of the fifth filter capacitor C10 is connected to the ground. The other end of the resistor R17 is connected to the fifth protection capacitor C9.

In some examples, a fifth disconnection threshold range for determining whether the third sensing line is disconnected may be set in advance. The fifth disconnection threshold range may be related to the voltage provided by the first power-supply terminal. If the circuit for detecting thermal runaway further includes a sleep/wake-up module P4 and the sleep/wake-up module P4 further includes a diode, the fifth disconnection threshold range may also be related to the diode.

In some examples, a fifth connection threshold range for determining whether the third sensing line is in normal connection may also be set in advance. The fifth connection threshold range may be related to the voltage provided by the first power-supply terminal, the seventh voltage-dividing resistor set, and the eighth voltage-dividing resistor set. If the circuit for detecting thermal runaway further includes a sleep/wake-up module P4 including a ninth voltage-dividing resistor set, then the fifth connection threshold range may also be related to the ninth voltage-dividing resistor set. If the sleep/wake-up module P4 further includes a diode, the fifth connection threshold range may also be related to the diode.

In some examples, if the voltage provided by the fourth power-supply terminal is higher than the voltage provided by the first power-supply terminal, the fifth disconnection threshold range and the fifth connection threshold range in the above embodiment may also be related to the fourth power-supply terminal, and the resistor and diode between the fourth power-supply terminal and the power module P5.

The processing module P3 may include a sampling port, a sensor, a third comparison circuit and a second determination circuit.

The sampling port may be connected to the fifth sampling point to acquire fifth sampled data from the fifth sampling point.

The sensor may be configured to collect the data for the battery set. In particular, the sensor may be a voltage sensor, a temperature sensor, a communication sensor, or the like, which is not limited herein.

The third comparison circuit may be connected to the sampling port, and configured to send a third disconnection signal if the fifth sampled data is within the fifth disconnection threshold range. The third disconnection signal ensures that the fifth sensing line is disconnected.

The second determination circuit may be connected to the third comparison circuit and the sensor. The second determination circuit may be connected to determine that thermal runaway occurs for the battery set if within a preset time period, the third disconnection signal is received, and at least one parameter in the data for the battery set meets a fault condition.

The data for the battery set may include at least one parameter.

For parameters and fault conditions in the data for the battery set, reference may be made to related descriptions in the above embodiments, and details will not be described herein again.

In some examples, the second determination circuit may further be configured to determine that thermal runaway occurs for the battery set, if within the preset time period, the third disconnection signal is not received, and at least one group of parameters in the data for the battery set meets the fault condition.

One group of parameters may include at least two parameters. For at least one group of parameters and fault conditions in the data for the battery set, reference may be made to related descriptions in the above embodiments, and details will not be described herein again.

It should be noted that if the fifth sampled data is neither within the fifth disconnection threshold range nor within the fifth connection threshold range, it may be determined that the sampling port for the fifth sampling point has failed.

If it is determined that the sampling port for the sampling point has failed, a prompt message for a sampling fault may be sent to prompt the vehicle controller to take corresponding measures or prompt relevant personnel.

In some examples, the second determination circuit may further be configured to send a thermal runaway warning message, if the third disconnection signal is not received, and the data for the battery set meets the fault condition.

The data for the battery set may include a maximum voltage of the single battery cell in the battery set during charging, an actual state of charge of the battery set during charging, and a charging current of the battery set during charging. The fault condition may include: a parameter exceeds a safety threshold range of the parameter.

Corresponding to specific parameters in the data for the battery set, the safety parameter threshold ranges may include a safety parameter threshold range of a voltage, a safety parameter threshold range of state of charge, and a safety parameter threshold range of a current.

In other words, if it is determined that the third sensing line is not disconnected, the maximum voltage of the single battery cell in the battery set during charging exceeds the safety parameter threshold range of a voltage, the actual state of charge of the battery set during charging exceeds the safety parameter threshold range of state of charge, and the charging current of the battery set during charging exceeds the safety parameter threshold range of a current, then it may be predicted that thermal runaway will occur for the battery set. A thermal runaway warning message may be sent, thereby taking corresponding measures in advance to avoid thermal runaway and to further improve the safety of the battery set.

Fig. 5 is a schematic structural diagram of a circuit for detecting thermal runaway according to still another embodiment of the present application. As shown in Fig. 5, the sensing line in the detection module P2 may include a cable-type temperature-sensing line. The sensing module P1 may further include a terminal resistor. The detection module P2 may include a group of voltage-dividing resistor sets.

The cable-type temperature-sensing line may be connected to the terminal resistor. Two steel wires inside the cable-type temperature-sensing wire that are wrapped with heat-sensitive materials may have a twisted pair structure. For example, as shown in Fig. 5, for ease of understanding, the cable-type temperature-sensing line may be shown as two separated cable-type temperature-sensing lines represented by two steel wires d and e. In an actual scenario, the two steel wires d and e may be located in a same cable-type temperature-sensing line. Under normal circumstances, the two steel wires in the cable-type temperature-sensing line do not intersect. When a temperature of some parts of the cable-type temperature-sensing wire rises sharply and exceeds the high temperature threshold, the heat-sensitive materials are melted with each other, so that the two steel wires in the cable-type temperature-sensing wire are twisted and connected together under the action of torsion, thereby causing a short-circuit in the cable-type temperature-sensing line. The high temperature threshold may be set according to specific operating scenarios and operating requirements, which is not limited herein. For example, the high temperature threshold may be 85 °C, 105 °C, or 125 ° C.

In some examples, in order to detect thermal runaway of the battery set in time, at least a portion of the cable-type temperature-sensing line may be disposed directly above the explosion-proof valve port of the single battery cell of the battery set. If thermal runaway occurs for the battery set, the explosion-proof valve of the battery cell will rupture, and high-temperature electrolyte, high-temperature gas, etc. will be ejected from the explosion-proof valve port of the battery cell. Disposing at least a portion of the cable-type temperature-sensing line directly above the explosion-proof valve port of the single battery cell in the battery set can make the cable-type temperature-sensing line more sensitive to the thermal runaway sensing of the battery set, thereby further improving the accuracy and timeliness of the thermal runaway detection.

Further, the cable-type temperature-sensing line may pass directly above the explosion-proof valve port of all single battery cells in the battery set. Specific settings for the cable-type temperature-sensing line may also be determined in combination with the internal structure of the battery set. For example, the battery set may be a battery pack including a plurality of battery modules, and a plurality of protective plates may be disposed in the battery set. For example, the cable-type temperature-sensing line may include a plurality of cable-type temperature-sensing line segments, each cable-type temperature-sensing line segment may be disposed in a protective plate, and each cable-type temperature-sensing line segment may be connected through other wiring harnesses, or connectors, etc.

The detection module P2 may include a tenth voltage-dividing resistor set and an eleventh voltage-dividing resistor set. One end of the tenth voltage-dividing resistor set may be connected to the first power-supply terminal, and one end of the eleventh voltage-dividing resistor set may be connected to the ground. The tenth voltage-dividing resistor set, the terminal resistor, and the eleventh voltage-dividing resistor set may be connected in series through the cable-type temperature-sensing line. Specifically, one steel wire in the cable-type temperature-sensing line connected to the terminal resistor may be connected to the other end of the tenth voltage-dividing resistor set, and the other steel wire in the cable-type temperature-sensing line may be connected to the other end of the eleventh voltage-dividing resistor set.

For example, as shown in Fig. 5, the tenth voltage-dividing resistor set may include a resistor R18, and the eleventh voltage-dividing resistor set may include a resistor R19. One end of the resistor R18 may be connected to the first power-supply terminal V1, and the other end of the resistor R18 and the terminal resistor Rx may be connected through the steel wire d in the cable-type temperature-sensing line. One end of the resistor R19 may be connected to the ground, and the other end of the resistor R19 and the terminal resistor Rx may be connected through the steel wire e in the cable-type temperature-sensing line.

The sampling point may include a sixth sampling point and a seventh sampling point. The sixth sampling point may be disposed between the other end of the tenth voltage-dividing resistor set and the terminal resistor, and the seventh sampling point may be disposed between the other end of the eleventh voltage-dividing resistor set and the terminal resistor.

As shown in Fig. 5, the sixth sampling point is labeled as AD6, and the seventh sampling point is labeled as AD7. The sixth sampling point AD6 is disposed between the resistor R18 and the terminal resistor Rx, and the seventh sampling point AD7 is disposed between the resistor R19 and the terminal resistor Rx.

In some examples, the processing module P3 may include a sampling port, a fourth comparison circuit, and a third determination circuit.

The sampling ports may be connected to the sixth sampling point and the seventh sampling point to acquire sixth sampled data and seventh sampled data from the sixth sampling point and the seventh sampling point, respectively. Specifically, for each sampling point, one sampling port may be set correspondingly, and the sampled data corresponding to the sampling point may be collected through the sampling port.

The fourth comparison circuit may be connected to the sampling ports, and may be configured to send a short-circuit signal if the sixth sampled data is the same as the seventh sampled data.

For example, the sixth sampled data and the seventh sampled data are both voltages. If a voltage collected from the sixth sampling point is equal to a voltage collected from the seventh sampling point, it may be determined that a short-circuit occurs in the cable-type temperature-sensing line. The short-circuit signal may indicate that a short-circuit occurs in the cable-type temperature-sensing line.

The third determination circuit may be connected to the fourth comparison circuit, and configured to determine that thermal runaway occurs for the battery set if the short-circuit signal is received.

Because a short-circuit condition for the cable-type temperature-sensing line is relatively severe, the cable-type temperature-sensing line generally will not be short-circuited under non-thermal runaway conditions. Therefore, if the cable-type temperature-sensing line is short-circuited, it may be determined that thermal runaway occurs for the battery set.

In other examples, the thermal runaway detection data may also include data for the battery set. The data for the battery set may include at least one parameter.

The processing module P3 may further include a sensor and a fifth comparison circuit.

The sensor may be configured to collect the data for the battery set. In particular, the sensor may be a voltage sensor, a temperature sensor, a communication sensor, or the like, which is not limited herein.

The fifth comparison circuit may be connected to the sampling ports and the first power-supply terminal, and configured to send a fourth disconnection signal if the sixth sampled data is the same as data provided by the first power-supply terminal and the seventh sampled data is the same as data provided by the ground.

For example, the sixth sampled data and the seventh sampled data are voltages. The voltage provided by the first power-supply terminal is 5V, and the voltage provided by the ground is 0V. If the sixth sampled data is 5V and the seventh sampled data is 0V, it may be determined that the cable-type temperature-sensing line is disconnected. The fourth disconnection signal may indicate that the cable-type temperature-sensing line is disconnected.

The third determination circuit may be configured to determine that thermal runaway occurs for the battery set if within a preset time period, the fourth disconnection signal is received, and at least one parameter in the data for the battery set meets a fault condition.

For related contents of parameters and fault conditions in the data for the battery set, reference may be made to related descriptions in the above embodiments, and details will not be described herein again.

In still other examples, the thermal runaway detection data may further include the data for the battery set.

The third determination circuit may further be configured to determine that thermal runaway occurs for the battery set if the fourth disconnection signal and the short-circuit signal are not received, and at least one group of parameters in the data for the battery set meets the fault condition, wherein one group of parameters may include at least two parameters.

For related contents of parameters and fault conditions in the data for the battery set, reference may be made to related descriptions in the above embodiments, and details will not be described herein again.

In still other examples, the thermal runaway detection data may further include the data for the battery set.

The third determination circuit may be further configured to send a thermal runaway warning message if the fourth disconnection signal and the short-circuit signal are not received, and the data for the battery set meets the fault condition.

The data for the battery set may include a maximum voltage of the single battery cell in the battery set during charging, an actual state of charge of the battery set during charging, and a charging current of the battery set during charging. The fault condition may include: a parameter exceeds a safety threshold range of the parameter.

For related contents of parameters and fault conditions in the data for the battery set, reference may be made to related descriptions in the above embodiments, and details will not be described herein again.

If thermal runaway occurs for the battery set while the BMU is in the sleep state, the BMU stops the data monitoring of the battery set and cannot provide the thermal runaway detection data. If the function of the processing module P3 is integrated in the BMU, and the BMU is in the sleep state, it is also impossible to detect and determine thermal runaway.

In order to detect thermal runaway in time while the BMU is in the sleep state, the detection module P2 in the above embodiments may further include a sleep/wake-up sub-module P21, and the sleep/wake-up sub-module P21 may include a first resistor set, a first switch tube, a second resistor set, a second switch tube, and a third resistor set.

One end of the first resistor set may be connected to a second power-supply terminal, and the other end of the first resistor set may be connected to a first terminal of the first switch tube and a control terminal of the second switch tube. A control terminal of the first switch tube may be connected to the other end of the second voltage-dividing resistor set, and a second terminal of the first switch tube may be connected to the ground. One end of the second resistor set may be connected to a third power-supply terminal, and the other end of the second resistor set may be connected to a first terminal of the second switch tube. A second terminal of the second switch tube may be connected to one end of the third resistor set and the power module P5 of the battery management unit. The other end of the third resistor set may be connected to the ground.

The voltages provided by the first power-supply terminal, the second power-supply terminal, and the third power-supply terminal may be the same or different, which is not limited herein. Specifically, the voltages provided by the first power-supply terminal, the second power-supply terminal, and the third power-supply terminal may be set according to specific operating scenarios and operating requirements.

The first switch tube and the second switch tube may be metal-oxide-semiconductor (MOS) tubes or other switch tubes, which is not limited herein.

For example, as shown in Fig. 5, the first resistor set includes a resistor R20, the second resistor set includes a resistor R21, and the third resistor set includes a resistor R22. The first switch tube is an N-channel MOS transistor Q1. The control terminal of the first switch tube Q1 is a gate electrode, the first terminal of the first switch tube Q1 is a drain electrode, and the second terminal of the first switch tube Q1 is a source electrode. The second switch tube is a P-channel MOS transistor Q2. The control terminal of the second switch tube Q2 is a gate electrode, the first terminal is a source electrode, and the second terminal is a drain electrode.

When the BMU is in the sleep state and thermal runaway occurs for the battery set, the cable-type temperature-sensing line is melted and short-circuited. A potential of the control terminal of the first switch tube is pulled up, and the first switch tube is turned on. A potential of the control terminal of the second switch tube is pulled down to a turn-on voltage drop of the first switch tube, and the second switch tube is turned on. A wake-up signal may be sent to the power module P5 through a wake-up signal line between the second terminal of the second switch tube and the power module P5 of the BMU to wake up the BMU. For example, before the sleep/wake-up module P4 sends a wake-up signal, a potential on a connection line between the sleep/wake-up module P4 and the power module P5 is grounded to 0V After the second switch tube is turned on, the potential on the connection line between the sleep/wake-up module P4 and the power module P5 is pulled up to wake up the BMU.

It should be noted that if the BMU is in the operating state, a fourth power-supply terminal may continuously provide a wake-up signal to the power module P5 of the BMU. The fourth power-supply terminal may be powered on when the BMU is in the operating state, so as to ensure that the wake-up signal may be continuously provided to the BMU. The fourth power-supply terminal may be powered off when the BMU is in the sleep state, and the BMU may be woken up by the sleep/wake-up sub-module P21. As shown in Fig. 5, a resistor R23 may be disposed between the fourth power-supply terminal V4 and the BMU. A value of the voltage provided by the fourth power-supply terminal V4 and the values of the voltage provided by the first power-supply terminal, the second power-supply terminal, and the third power-supply terminal may be the same or different, which is not limited herein. For example, the voltage provided by the fourth power-supply terminal is 12V

In some examples, the detection module P2 of the circuit for detecting thermal runaway may further include some protection devices and/or filtering devices. Specifically, the protection devices may include a protection capacitor and the like. The protection capacitor can prevent the occurrence of Electro Static Discharge (ESD) in the circuit for detecting thermal runaway. The filtering devices may include a filter capacitor, a filter resistor, and the like. The filter resistor and the filter capacitor may form an RC filter circuit to filter the sampled data of the sampling point to improve the accuracy of the sampled data, thereby improving the accuracy of the thermal runaway detection.

One end of a protection capacitor may be connected to one end of a voltage-dividing resistor set that a sampling point is connected to, and the other end of the protection capacitor may be connected to the ground. One end of a filter capacitor may be connected to one end of a filter resistor and a sampling point, the other end of the filter capacitor may be connected to the ground, and the other end of the filter resistor may be connected to one end of the protection capacitor.

For example, as shown in Fig. 5, the protection capacitors may include a sixth protection capacitor C11 and a seventh protection capacitor C12. The filter capacitor may include a sixth filter capacitor C13 and a seventh filter capacitor C14. The filter resistor may include a sixth filter resistor R24 and a seventh filter resistor R25.

One end of the sixth protection capacitor C11 may be connected to one end of the resistor R18 that the sixth sampling point AD6 is connected to. One end of the seventh protection capacitor C12 may be connected to one end of the resistor R19 that the seventh sampling point AD7 is connected to. The other end of the sixth protection capacitor C11 and the other end of the seventh protection capacitor C12 may be connected to the ground.

One end of the sixth filter capacitor C13 may be connected to one end of the resistor R24 and the sixth sampling point AD6. One end of the seventh filter capacitor C14 may be connected to one end of the resistor R25 and the seventh sampling point AD7. The other end of the sixth filter capacitor C13 and the other end of the seventh filter capacitor C14 may be connected to the ground. The other end of the resistor R24 may be connected to one end of the sixth protection capacitor C11. The other end of the resistor R25 may be connected to one end of the seventh protection capacitor C12.

## Claims

1. A circuit for detecting thermal runaway in a battery set, **characterized by** comprising:
a sensing module (P1) comprising a sensing line (a, b, c, d, e), wherein a distance between at least a portion of the sensing line (a, b, c, d, e) and a single battery cell in the battery set is less than a temperature-sensing distance threshold;
a detection module (P2) connected to the sensing line (a, b, c, d, e) and comprising at least one group of voltage-dividing resistor sets, wherein one end of each group of voltage-dividing resistor sets is configured to be connected to a first power-supply terminal (V1), the other end of each group of voltage-dividing resistor sets is configured to be connected to ground, and each group of voltage-dividing resistor sets comprises at least two voltage-dividing resistor sets connected in series, wherein each of the at least two voltage-dividing resistor sets comprises at least a resistor (R1, R2, R3, R4, R5, R6, R7, R8, R18, R19);
**characterized by**:
a processing module (P3) connected to the detection module (P2) and configured to
acquire thermal runaway detection data, wherein the thermal runaway detection data comprises sampled electrical signal data collected from one or more sampling points (AD1, AD2, AD3, AD4, AD5, AD6, AD7) disposed respectively between two connected voltage-dividing resistor sets, wherein the sensing line (a, b, c, d, e) is connected to the sampling points (AD1, AD2, AD3, AD4, AD5, AD6, AD7);
determine an on-off state of the sensing line (a, b, c, d, e) based on the sampled electrical signal data, the on-off state comprises short-circuit, disconnected or normal connection; and
determine whether thermal runaway has occurred for the battery set based on the on-off state of the sensing line (a, b, c, d, e).

2. The circuit of claim 1, wherein at least a portion of the sensing line (a, b, c, d, e) is configured to be located directly above an explosion-proof valve port of the single battery cell in the battery set.

3. The circuit of claim 2, wherein:
the sensing line (a, b) ^comprises a first sensing line (a) and a second sensing line (b) configured to be disposed on a circuit board above the battery set;
the sampling points (AD1, AD2, AD3, AD4) comprises a first sampling point (AD1), a second sampling point (AD2), a third sampling point (AD3), and a fourth sampling point (AD4);
the detection module (P2) comprises a first group of voltage-dividing resistor sets (R1, R2, R3) and a second group of voltage-dividing resistor sets (R4, R5, R6);
the first group of voltage-dividing resistor sets (R1, R2, R3) comprises a first voltage-dividing resistor set (R1), a second voltage-dividing resistor set (R2), and a third voltage-dividing resistor set (R3) connected in series, one end of the first voltage-dividing resistor set (R1) is configured to be connected to the first power-supply terminal (V 1), one end of the third voltage-dividing resistor set (R3) is configured to be connected to ground, the first sampling point (AD 1) is disposed between the first voltage-dividing resistor set (R1) and the second voltage-dividing resistor set (R2), the second sampling point (AD2) is disposed between the second voltage-dividing resistor set (R2) and the third voltage-dividing resistor set (R3), one end of the first sensing line (a) is connected to the first sampling point (AD 1), and the other end of the first sensing line (a) is connected to the second sampling point (AD2); the second group of voltage-dividing resistor sets (R4, R5, R6) comprises a fourth voltage-dividing resistor set (R4), a fifth voltage-dividing resistor set (R5), and a sixth voltage-dividing resistor set (R6) connected in series, one end of the fourth voltage-dividing resistor set (R4) is configured to be connected to the first power-supply terminal (V 1), one end of the sixth voltage-dividing resistor set (R6) is configured to be connected to ground, the third sampling point (AD3) is disposed between the fourth voltage-dividing resistor set (R4) and the fifth voltage-dividing resistor set (R5), and the fourth sampling point (AD4) is disposed between the fifth voltage-dividing resistor set (R5) and the sixth voltage-dividing resistor set (R6), one end of the second sensing line (b) is connected to the third sampling point (AD3), and the other end of the second sensing line (b) is connected to the fourth sampling point (AD4).

4. The circuit of claim 3, wherein the thermal runaway detection data further comprises data for the battery set, and the data for the battery set comprises at least one parameter, the at least one parameter comprises a temperature, a voltage, a fault, and an effectiveness of external communication for the battery set;
the processing module (P3) comprises:
a sampling port connected to the first sampling point (AD1), the second sampling point (AD2), the third sampling point (AD3), and the fourth sampling point (AD4) to acquire first sampled electrical signal data. second sampled electrical signal data, third sampled electrical signal data, and fourth sampled electrical signal data from the first sampling point (AD 1). the second sampling point (AD2), the third sampling point (AD3), and the fourth sampling point (AD4), respectively;
a sensor configured to collect the data for the battery set;
a first comparison circuit connected to the sampling port and configured to send a first disconnection signal if the first sampled electrical signal data is within a first disconnection threshold range and the second sampled electrical signal data is within a second disconnection threshold range, wherein the first disconnection signal indicates that the first sensing line (a) is disconnected;
a second comparison circuit connected to the sampling port and configured to send a second disconnection signal if the third sampled electrical signal data is within a third disconnection threshold range and the fourth sampled electrical signal data is within a fourth disconnection threshold range, the second disconnection signal indicates that the second sensing line (b) is disconnected;
a first determination circuit connected to the first comparison circuit, the second comparison circuit, and the sensor, and configured to determine that thermal runaway occurs for the battery set if within a preset time period, the first disconnection signal and the second disconnection signal are received, and at least one parameter in the data for the battery set meets a fault condition.

5. The circuit of claim 4, wherein the first determination circuit is further configured to:
determine that thermal runaway occurs for the battery set, if within the preset time period, the first disconnection signal and/or the second disconnection signal are not received, and at least one group of parameters in the data for the battery set meets the fault condition, wherein the at least one group of parameters comprises at least two parameters.

6. The circuit of claim 4, wherein the first determination circuit is further configured to:
send a thermal runaway warning message, if the first disconnection signal and/or the second disconnection signal are not received, and the data for the battery set meets the fault condition,
wherein, the data for the battery set comprises a maximum voltage of the single battery cell in the battery set during charging, an actual state of charge of the battery set during charging, and a charging current of the battery set during charging,
the fault condition comprises: a parameter exceeds a safety threshold range of the parameter.

7. The circuit of claim 2, further comprising:
a sleep/wake-up module (P4) configured to be disposed between the first power-supply terminal (V1) and all groups of voltage-dividing resistor sets, and configured to send a control signal to a power module (P5) of a battery management unit when the battery management unit is in a sleep state,
wherein the control signal is to instruct the power module (P5) to control the battery management unit to remain in the sleep state or switch to an operating state.

8. The circuit of claim 7, wherein:
the sleep/wake-up module (P4) comprises a ninth voltage-dividing resistor set (R9), or
the sleep/wake-up module (P4) comprises a ninth voltage-dividing resistor set (R9) and a diode (D1),
wherein an anode of the diode (D 1) is connected to the ninth voltage-dividing resistor set (R9), and a cathode of the diode (D1) is connected to the power module (P5).

9. The circuit of claim 4, wherein the data for the battery set comprises one or more of the following parameters:
a maximum temperature of the single battery cell in the battery set, a temperature change rate of the single battery cell in the battery set, a difference between the maximum temperature and a minimum temperature of the single battery cell in the battery set, a minimum voltage of the single battery cell in the battery set, the number of disconnection faults of voltage sampling of the battery set, a temperature-sensing fault parameter, and a communication fault parameter for monitoring of a battery cell,
wherein the fault condition comprises: a parameter exceeds a safety threshold range of the parameter, or a parameter indicates a fault.

10. The circuit of claim 5, wherein the at least one group of parameters comprises any of the following groups of parameters:
a minimum voltage of the single battery cell in the battery set and a maximum temperature of the single battery cell in the battery set,
the minimum voltage of the single battery cell in the battery set and a temperature change rate of the single battery cell in the battery set,
the minimum voltage of the single battery cell in the battery set and a difference between the maximum temperature and a minimum temperature of the single battery cell in the battery set,
the temperature change rate of the single battery cell in the battery set and the maximum temperature of the single battery cell in the battery set,
the temperature change rate of the single battery cell in the battery set and the difference between the maximum temperature and the minimum temperature of the single battery cell in the battery set,
the number of disconnection faults of voltage sampling of the battery set and the maximum temperature of the single battery cell in the battery set,
the number of disconnection faults of voltage sampling of the battery set and the temperature change rate of the single battery cell in the battery set,
the number of disconnection faults of voltage sampling of the battery set and the difference between the maximum temperature and the minimum temperature of the single battery cell in the battery set,
the number of disconnection faults of voltage sampling of the battery set and a temperature-sensing fault parameter,
wherein the fault condition comprises: a parameter exceeds a safety threshold range of the parameter, or a parameter indicates a fault.

## Patentansprüche

1. Schaltung zum Erkennen eines thermischen Durchgehens in einem Batteriesatz, **dadurch gekennzeichnet, dass** sie Folgendes umfasst:
ein Erfassungsmodul (P1), das eine Erfassungsleitung (a, b, c, d, e) umfasst, wobei ein Abstand zwischen mindestens einem Teil der Erfassungsleitung (a, b, c, d, e) und einer einzelnen Batteriezelle im Batteriesatz kleiner als eine Temperaturerfassungsabstandsschwelle ist;
ein Erfassungsmodul (P2), das mit der Erfassungsleitung (a, b, c, d, e) verbunden ist und mindestens eine Gruppe von Spannungsteilungswiderstandssätzen umfasst, wobei ein Ende jeder Gruppe von Spannungsteilungswiderstandssätzen zum Verbinden mit einem ersten Stromversorgungsanschluss (V1) konfiguriert ist, das andere Ende jeder Gruppe von Spannungsteilungswiderstandssätzen zum Verbinden mit Erde konfiguriert ist, und jede Gruppe von Spannungsteilungswiderstandssätzen mindestens zwei in Reihe geschaltete Spannungsteilungswiderstandssätze umfasst, wobei jeder der mindestens zwei Spannungsteilungswiderstandssätze mindestens einen Widerstand (R1, R2, R3, R4, R5, R6, R7, R8, R18, R19) umfasst;
**gekennzeichnet dadurch, dass**:
ein Verarbeitungsmodul (P3), das mit dem Erfassungsmodul (P2) verbunden ist und zum Durchführen folgender Schritte konfiguriert ist:
Erfassen von Daten zur Erkennung des thermischen Durchgehens, wobei die Daten zur Erkennung des thermischen Durchgehens abgetastete elektrische Signaldaten umfassen, die von einem oder mehreren Abtastpunkten (AD 1, AD2, AD3, AD4, AD5, AD6, AD7) gesammelt wurden, die jeweils zwischen zwei verbundenen Spannungsteilungswiderstandssätzen angeordnet sind, wobei die Erfassungsleitung (a, b, c, d, e) mit den Abtastpunkten (AD1, AD2, AD3, AD4, AD5, AD6, AD7) verbunden ist;
Bestimmen eines Ein-Aus-Zustands der Erfassungsleitung (a, b, c, d, e) basierend auf den abgetasteten elektrischen Signaldaten, der Ein-Aus-Zustand einen Kurzschluss, eine Trennung oder eine normale Verbindung umfasst; und
Bestimmen, ob ein thermisches Durchgehen für den Batteriesatz aufgetreten ist, basierend auf dem Ein-Aus-Zustand der Erfassungsleitung (a, b, c, d, e).

2. Schaltung nach Anspruch 1, wobei mindestens ein Teil der Erfassungsleitung (a, b, c, d, e) so konfiguriert ist, dass sie sich direkt über einem explosionssicheren Ventilanschluss der einzelnen Batteriezelle im Batteriesatz befindet.

3. Schaltung nach Anspruch 2, wobei:
die Erfassungsleitung (a, b) eine erste Erfassungsleitung (a) und eine zweite Erfassungsleitung (b) umfasst, die so konfiguriert sind, dass sie auf einer Leiterplatte oberhalb des Batteriesatzes angeordnet sind;
die Abtastpunkte (AD1, AD2, AD3, AD4) einen ersten Abtastpunkt (AD1), einen zweiten Abtastpunkt (AD2), einen dritten Abtastpunkt (AD3) und einen vierten Abtastpunkt (AD4) umfassen;
das Erfassungsmodul (P2) eine erste Gruppe von Spannungsteilungswiderstandssätzen (R1, R2, R3) und eine zweite Gruppe von Spannungsteilungswiderstandssätzen (R4, R5, R6) umfasst;
die erste Gruppe von Spannungsteilungswiderstandssätzen (R1, R2, R3) einen ersten Spannungsteilungswiderstandssatz (R1), einen zweiten Spannungsteilungswiderstandssatz (R2) und einen dritten Spannungsteilungswiderstandssatz (R3) umfasst, die in Reihe geschaltet sind, ein Ende des ersten Spannungsteilungswiderstandssatzes (R1) zum Verbinden mit dem ersten Stromversorgungsanschluss (V1) konfiguriert ist, ein Ende des dritten Spannungsteilungswiderstandssatzes (R3) zum Verbinden mit Erde konfiguriert ist, der erste Abtastpunkt (AD1) zwischen dem ersten Spannungsteilungswiderstandssatz (R1) und dem zweiten Spannungsteilungswiderstandssatz (R2) angeordnet ist, der zweite Abtastpunkt (AD2) zwischen dem zweiten Spannungsteilungswiderstandssatz (R2) und dem dritten Spannungsteilungswiderstandssatz (R3) angeordnet ist, ein Ende der ersten Erfassungsleitung (a) mit dem ersten Abtastpunkt (AD1) verbunden ist und das andere Ende der ersten Erfassungsleitung (a) mit dem zweiten Abtastpunkt (AD2) verbunden ist;
die zweite Gruppe von Spannungsteilungswiderstandssätzen (R4, R5, R6) einen vierten Spannungsteilungswiderstandssatz (R4), einen fünften Spannungsteilungswiderstandssatz (R5) und einen sechsten Spannungsteilungswiderstandssatz (R6) umfasst, die in Reihe geschaltet sind, wobei ein Ende des vierten Spannungsteilungswiderstandssatzes (R4) zum Verbinden mit dem ersten Stromversorgungsanschluss (V1) konfiguriert ist, und ein Ende des sechsten Spannungsteilungswiderstandssatzes (R6) zum Verbinden mit Erde konfiguriert ist, der dritte Abtastpunkt (AD3) zwischen dem vierten Spannungsteilungswiderstandssatz (R4) und dem fünften Spannungsteilungswiderstandssatz (R5) angeordnet ist und der vierte Abtastpunkt (AD4) zwischen dem fünften Spannungsteilungswiderstandssatz (R5) und dem sechsten Spannungsteilungswiderstandssatz (R6) angeordnet ist, ein Ende der zweiten Erfassungsleitung (b) mit dem dritten Abtastpunkt (AD3) verbunden ist und das andere Ende der zweiten Erfassungsleitung (b) mit dem vierten Abtastpunkt (AD4) verbunden ist.

4. Schaltung nach Anspruch 3, wobei die Daten zur Erkennung des thermischen Durchgehens ferner Daten für den Batteriesatz umfassen, und die Daten für den Batteriesatz mindestens einen Parameter umfassen, der mindestens eine Parameter eine Temperatur, eine Spannung, einen Fehler und eine Effektivität der externen Kommunikation für den Batteriesatz umfasst,
das Verarbeitungsmodul (P3) Folgendes umfasst:
einen Abtastanschluss, der mit dem ersten Abtastpunkt (AD1), dem zweiten Abtastpunkt (AD2), dem dritten Abtastpunkt (AD3) und dem vierten Abtastpunkt (AD4) verbunden ist, zum Erfassen von ersten abgetasteten elektrischen Signaldaten, zweiten abgetasteten elektrischen Signaldaten, dritten abgetasteten elektrischen Signaldaten und vierten abgetasteten elektrischen Signaldaten jeweils von dem ersten Abtastpunkt (AD 1), dem zweiten Abtastpunkt (AD2), dem dritten Abtastpunkt (AD3) und dem vierten Abtastpunkt (AD4);
einen Sensor, der dazu konfiguriert ist, die Daten für den Batteriesatz zu sammeln;
eine erste Vergleichsschaltung, die mit dem Abtastanschluss verbunden und so konfiguriert ist, dass sie ein erstes Trennsignal sendet, wenn die ersten abgetasteten elektrischen Signaldaten innerhalb eines ersten Trennschwellenbereichs liegen und die zweiten abgetasteten elektrischen Signaldaten innerhalb eines zweiten Trennschwellenbereichs liegen, wobei das erste Trennsignal anzeigt, dass die erste Erfassungsleitung (a) getrennt ist;
eine zweite Vergleichsschaltung, die mit dem Abtastanschluss verbunden und so konfiguriert ist, dass sie ein zweites Trennsignal sendet, wenn die dritten abgetasteten elektrischen Signaldaten innerhalb eines dritten Trennschwellenbereichs liegen und die vierten abgetasteten elektrischen Signaldaten innerhalb eines vierten Trennschwellenbereichs liegen, wobei das zweite Trennsignal anzeigt, dass die zweite Erfassungsleitung (b) getrennt ist;
eine erste Bestimmungsschaltung, die mit der ersten Vergleichsschaltung, der zweiten Vergleichsschaltung und dem Sensor verbunden und so konfiguriert ist, dass sie bestimmt, dass ein thermisches Durchgehen für den Batteriesatz auftritt, wenn das erste Trennsignal und das zweite Trennsignal innerhalb einer voreingestellten Zeitspanne empfangen werden und mindestens ein Parameter in den Daten für den Batteriesatz eine Fehlerbedingung erfüllt.

5. Schaltung nach Anspruch 4, wobei die erste Bestimmungsschaltung ferner zum Durchführen folgendes Schritts konfiguriert ist:
Bestimmen, dass ein thermisches Durchgehen für den Batteriesatz auftritt, wenn das erste Trennsignal und/oder das zweite Trennsignal innerhalb der voreingestellten Zeitspanne nicht empfangen werden, und mindestens eine Gruppe von Parametern in den Daten für den Batteriesatz die Fehlerbedingung erfüllt, wobei die mindestens eine Gruppe von Parametern mindestens zwei Parameter umfasst.

6. Schaltung nach Anspruch 4, wobei die erste Bestimmungsschaltung ferner zum Durchführen folgender Schritte konfiguriert ist:
Senden einer Warnung vor thermischem Durchgehen, wenn das erste Trennsignal und/oder das zweite Trennsignal nicht empfangen werden und die Daten für den Batteriesatz die Fehlerbedingung erfüllen,
wobei die Daten für den Batteriesatz eine maximale Spannung der einzelnen Batteriezelle im Batteriesatz während des Aufladens, einen tatsächlichen Ladezustand des Batteriesatzes während des Aufladens und eine Aufladestrom des Batteriesatzes während des Aufladens umfassen,
die Fehlerbedingung Folgendes umfasst: ein Parameter einen Sicherheitsschwellenbereich des Parameters überschreitet.

7. Schaltung nach Anspruch 2, ferner umfassend:
ein Schlaf/Aufweck-Modul (P4), das so konfiguriert ist, dass es zwischen dem ersten Stromversorgungsanschluss (V1) und allen Gruppen von Spannungsteilungswiderstandssätzen angeordnet ist, und so konfiguriert ist, dass es ein Steuersignal an ein Stromversorgungsmodul (P5) einer Batterieverwaltungseinheit sendet, wenn sich die Batterieverwaltungseinheit in einem Schlafzustand befindet,
wobei das Steuersignal das Stromversorgungsmodul (P5) anweisen soll, die Batterieverwaltungseinheit so zu steuern, dass sie im Schlafzustand verbleibt oder in einen Betriebszustand übergeht.

8. Schaltung nach Anspruch 7, wobei:
das Schlaf/Aufweck-Modul (P4) einen neunten Spannungsteilungswiderstandssatz (R9) umfasst, oder
das Schlaf/Aufweck-Modul (P4) einen neunten Spannungsteilungswiderstandssatz (R9) und eine Diode (D1) umfasst, wobei eine Anode der Diode (D1) mit dem neunten Spannungsteilungswiderstandssatz (R9) verbunden ist und eine Kathode der Diode (D1) mit dem Stromversorgungsmodul (P5) verbunden ist.

9. Schaltung nach Anspruch 4, wobei die Daten für den Batteriesatz einen oder mehrere der folgenden Parameter umfassen:
eine maximale Temperatur der einzelnen Batteriezelle im Batteriesatz, eine Temperaturänderungsrate der einzelnen Batteriezelle im Batteriesatz, eine Differenz zwischen der maximalen Temperatur und einer minimalen Temperatur der einzelnen Batteriezelle im Batteriesatz, eine minimale Spannung der einzelnen Batteriezelle im Batteriesatz, die Anzahl von Trennungsfehlern der Spannungsabtastung des Batteriesatzes, einen Temperaturerfassungsfehlerparameter und einen Kommunikationsfehlerparameter zur Überwachung einer Batteriezelle,
wobei die Fehlerbedingung Folgendes umfasst: ein Parameter einen Sicherheitsschwellenbereich des Parameters überschreitet, oder ein Parameter einen Fehler anzeigt.

10. Schaltung nach Anspruch 5, wobei die mindestens eine Gruppe von Parametern eine der folgenden Gruppen von Parametern umfasst:
eine minimale Spannung der einzelnen Batteriezelle im Batteriesatz und eine maximale Temperatur der einzelnen Batteriezelle im Batteriesatz,
die minimale Spannung der einzelnen Batteriezelle im Batteriesatz und eine Temperaturänderungsrate der einzelnen Batteriezelle im Batteriesatz,
die minimale Spannung der einzelnen Batteriezelle im Batteriesatz und eine Differenz zwischen der maximalen Temperatur und einer minimalen Temperatur der einzelnen Batteriezelle im Batteriesatz,
die Temperaturänderungsrate der einzelnen Batteriezelle im Batteriesatz und die maximale Temperatur der einzelnen Batteriezelle im Batteriesatz,
die Temperaturänderungsrate der einzelnen Batteriezelle im Batteriesatz und die Differenz zwischen der maximalen Temperatur und der minimalen Temperatur der einzelnen Batteriezelle im Batteriesatz,
die Anzahl der Trennungsfehler bei der Spannungsabtastung des Batteriesatzes und die maximale Temperatur der einzelnen Batteriezelle im Batteriesatz,
die Anzahl der Trennungsfehler bei der Spannungsabtastung des Batteriesatzes und die Temperaturänderungsrate der einzelnen Batteriezelle im Batteriesatz,
die Anzahl der Trennungsfehler bei der Spannungsabtastung des Batteriesatzes und die Differenz zwischen der maximalen Temperatur und der minimalen Temperatur der einzelnen Batteriezelle im Batteriesatz,
die Anzahl der Trennungsfehler bei der Spannungsabtastung des Batteriesatzes und ein Temperaturerfassungsfehlerparameter,
wobei die Fehlerbedingung Folgendes umfasst: ein Parameter einen Sicherheitsschwellenbereich des Parameters überschreitet, oder ein Parameter einen Fehler anzeigt.

## Revendications

1. Circuit de détection d'emballement thermique dans un jeu de batteries, **caractérisé en ce qu'**il comprend :
un module d'induction (P1) comprenant une ligne d'induction (a, b, c, d, e), dans lequel une distance entre au moins une partie de la ligne d'induction (a, b, c, d, e) et une seule cellule de batterie dans le jeu de batteries est inférieure à un seuil de distance d'induction de température ;
un module de détection (P2) connecté à la ligne d'induction (a, b, c, d, e) et comprenant au moins un groupe de jeux de résistances diviseurs de tension, dans lequel une extrémité de chaque groupe de jeux de résistances diviseurs de tension est configurée pour être connectée à une première borne d'alimentation de puissance (V1), l'autre extrémité de chaque groupe de jeux de résistances diviseurs de tension est configurée pour être connectée à la terre, et chaque groupe de jeux de résistances diviseurs de tension comprend au moins deux jeux de résistances diviseurs de tension connectés en série, dans lesquels chacun des deux jeux de résistances diviseurs de tension comprend au moins une résistance (R1, R2, R3, R4, R5, R6, R7, R8, R18, R19) ;
**caractérisé en ce que**,
un module de traitement (P3) connecté au module de détection (P2) et configuré pour
acquérir des données de détection d'emballement thermique, dans lequel les données de détection d'emballement thermique comprennent des données de signal électrique échantillonnées qui sont collectées à partir d'un ou plusieurs points d'échantillonnage (AD1, AD2, AD3, AD4, AD5, AD6, AD7) disposés respectivement entre deux jeux de résistances diviseurs de tension connectés, dans lequel la ligne d'induction (a, b, c, d, e) est connectée aux points d'échantillonnage (AD1, AD2, AD3, AD4, AD5, AD6, AD7) ;
déterminer un état activé-désactivé de la ligne d'induction (a, b, c, d, e) sur la base des données de signal électrique échantillonnées, l'état activé-désactivé comprenant un court-circuit, une déconnexion ou une connexion normale ; et
déterminer si un emballement thermique s'est produit dans le jeu de batteries sur la base de l'état activé-désactivé de la ligne d'induction (a, b, c, d, e).

2. Circuit selon la revendication 1, dans lequel au moins une portion de la ligne d'induction (a, b, c, d, e) est configurée pour être située directement au-dessus d'un port de vanne antidéflagrante de la seule cellule de batterie dans le jeu de batteries.

3. Circuit selon la revendication 2, dans lequel :
la ligne d'induction (a, b) comprend une première ligne d'induction (a) et une deuxième ligne d'induction (b) configurées pour être disposées sur une carte de circuit imprimé au-dessus du jeu de batteries ;
les points d'échantillonnage (AD1, AD2, AD3, AD4) comprennent un premier point d'échantillonnage (AD1), un deuxième point d'échantillonnage (AD2), un troisième point d'échantillonnage (AD3) et un quatrième point d'échantillonnage (AD4) ;
le module de détection (P2) comprend un premier groupe de jeux de résistances diviseurs de tension (R1, R2, R3) et un deuxième groupe de jeux de résistances diviseurs de tension (R4, R5, R6)
le premier groupe de jeux de résistances diviseurs de tension (R1, R2, R3) comprend un premier jeu de résistances diviseurs de tension (R1), un deuxième jeu de résistances diviseurs de tension (R2) et un troisième jeu de résistances diviseurs de tension (R3) connectés en série, une extrémité du premier jeu de résistances diviseurs de tension (R1) est configurée pour être connectée à la première borne d'alimentation de puissance (V1), une extrémité du troisième jeu de résistances diviseurs de tension (R3) est configurée pour être connectée à la masse, le premier point d'échantillonnage (AD1) est disposé entre le premier jeu de résistances diviseurs de tension (R1) et le deuxième jeu de résistances diviseurs de tension (R2), le deuxième point d'échantillonnage (AD2) est disposé entre le deuxième jeu de résistances diviseurs de tension (R2) et le troisième jeu de résistances diviseurs de tension (R3), une extrémité de la première ligne d'induction (a) est connectée au premier point d'échantillonnage (AD1), et l'autre extrémité de la première ligne d'induction (a) est connectée au deuxième point d'échantillonnage (AD2) ;
le deuxième groupe de jeux de résistances diviseurs de tension (R4, R5, R6) comprend un quatrième jeu de résistances diviseurs de tension (R4), un cinquième jeu de résistances diviseurs de tension (R5) et un sixième jeu de résistances diviseurs de tension (R6) connectés en série, une extrémité du quatrième jeu de résistances diviseurs de tension (R4) est configurée pour être connectée à la première borne d'alimentation de puissance (V1), une extrémité du sixième jeu de résistances diviseurs de tension (R6) est configurée pour être connectée à la masse, le troisième point d'échantillonnage (AD3) est disposé entre le quatrième jeu de résistances diviseurs de tension (R4) et le cinquième jeu de résistances diviseurs de tension (R5), et le quatrième point d'échantillonnage (AD4) est disposé entre le cinquième jeu de résistances diviseurs de tension (R5) et le sixième jeu de résistances diviseurs de tension (R6),
une extrémité de la deuxième ligne d'induction (b) est connectée au troisième point d'échantillonnage (AD3), et l'autre extrémité de la deuxième ligne d'induction (b) est connectée au quatrième point d'échantillonnage (AD4).

4. Circuit selon la revendication 3, dans lequel les données de détection d'emballement thermique comprennent en outre des données relatives au jeu de batteries, et les données relatives au jeu de batteries comprennent au moins un paramètre, et l'au moins un paramètre comprend une température, une tension, un défaut, et une efficacité de communication externe pour le jeu de batteries ;
le module de traitement (P3) comprend :
un port d'échantillonnage connecté au premier point d'échantillonnage (AD1), au deuxième point d'échantillonnage (AD2), au troisième point d'échantillonnage (AD3) et au quatrième point d'échantillonnage (AD4) pour acquérir les premières données de signal électrique échantillonnées,
des deuxièmes données de signal électrique échantillonnées, des troisièmes données de signal électrique échantillonnées et des quatrièmes données de signal électrique échantillonnées du premier point d'échantillonnage (AD1),
le deuxième point d'échantillonnage (AD2), le troisième point d'échantillonnage (AD3) et le quatrième point d'échantillonnage (AD4), respectivement ;
un capteur configuré pour collecter les données relatives au jeu de batteries ;
un premier circuit de comparaison connecté au port d'échantillonnage et configuré pour envoyer un premier signal de déconnexion si les premières données de signal électrique échantillonnées sont situées dans une première plage de seuils de déconnexion et les deuxièmes données de signal électrique échantillonnées sont situées dans une deuxième plage de seuils de déconnexion, dans lequel le premier signal de déconnexion indique que la première ligne d'induction (a) est déconnectée
un deuxième circuit de comparaison connecté au port d'échantillonnage et configuré pour envoyer un deuxième signal de déconnexion si les données du troisième signal électrique échantillonné sont situées dans une troisième plage de seuils de déconnexion et les données du quatrième signal électrique échantillonnées sont situées dans une quatrième plage de seuils de déconnexion, le deuxième signal de déconnexion indique que la deuxième ligne d'induction (b) est déconnectée ;
un premier circuit de détermination connecté au premier circuit de comparaison, au deuxième circuit de comparaison et au capteur, et configuré pour déterminer que l'emballement thermique se produit dans le jeu de batteries si, pendant une durée prédéfinie, le premier signal de déconnexion et le deuxième signal de déconnexion sont reçus et au moins un paramètre dans les données relatives au jeu de batteries répond à une condition de défaut.

5. Circuit selon la revendication 4, dans lequel le premier circuit de détermination est configuré en outre pour :
déterminer que l'emballement thermique se produit dans le jeu de batteries si, pendant la durée prédéfinie, le premier signal de déconnexion et/ou le deuxième signal de déconnexion ne sont pas reçus et au moins un groupe de paramètres dans les données relatives au jeu de batteries répond à la condition de défaut, dans lequel au moins un groupe de paramètres comprend au moins deux paramètres.

6. Circuit selon la revendication 4, dans lequel le premier circuit de détermination est configuré en outre pour :
envoyer un message d'avertissement d'emballement thermique, si le premier signal de déconnexion et/ou le deuxième signal de déconnexion ne sont pas reçus et les données relatives au jeu de batteries répondent à la condition de défaut,
dans lequel les données relatives au jeu de batteries comprennent une tension maximale de la seule cellule de batterie dans le jeu de batteries pendant la recharge, un état réel de recharge du jeu de batteries pendant la recharge et un courant de recharge de la batterie pendant la recharge,
la condition de défaut comprend : un paramètre dépasse une plage de seuils de sécurité du paramètre.

7. Circuit selon la revendication 2, comprenant en outre :
un module veille/réveil (P4) configuré pour être disposé entre la première borne d'alimentation de puissance (V1) et tous les groupes de jeux de résistances diviseurs de tension, et configuré pour envoyer un signal de commande à un module de puissance (P5) d'une unité de gestion de batteries lorsque l'unité de gestion de batteries est en état de veille,
dans lequel le signal de commande sert à indiquer le module de puissance (P5) de commander l'unité de gestion de la batterie à rester en état de veille ou à passer à un état de fonctionnement.

8. Circuit selon la revendication 7, dans lequel :
le module veille/réveil (P4) comprend un neuvième jeu de résistances diviseurs de tension (R9), ou
le module veille/réveil (P4) comprend un neuvième jeu de résistances diviseurs de tension (R9) et une diode (D1),
dans lequel une anode de la diode (D1) est connectée au neuvième jeu de résistances diviseurs de tension (R9), et une cathode de la diode (D1) est connectée au module de puissance (P5).

9. Circuit selon la revendication 4, dans lequel les données relatives au jeu de batteries comprennent un ou plusieurs des paramètres suivants :
une température maximale de la seule cellule de batterie dans le jeu de batteries, un taux de changement de température de la seule cellule de batterie dans le jeu de batteries, une différence entre la température maximale et une température minimale de la seule cellule de batterie dans le jeu de batteries, une tension minimale de la seule cellule de batterie dans le jeu de batteries, le nombre de défauts de déconnexion de l'échantillonnage de tension du jeu de batteries, un paramètre de défaut d'induction de température et un paramètre de défaut de communication de la surveillance d'une cellule de batterie,
dans lequel la condition de défaut comprend : un paramètre dépasse une plage de seuils de sécurité du paramètre, ou un paramètre indique un défaut.

10. Circuit selon la revendication 5, dans lequel au moins un groupe de paramètres comprend l'un des groupes de paramètres suivants :
une tension minimale de la seule cellule de batterie dans le jeu de batteries et une température maximale de la seule cellule de batterie dans le jeu de batteries,
la tension minimale de la seule cellule de batterie dans le jeu de batteries et un taux de changement de température de la seule cellule de batterie dans le jeu de batteries,
la tension minimale de la seule cellule de batterie dans le jeu de batteries et une différence entre la température maximale et une température minimale de la seule cellule de batterie dans le jeu de batteries,
le taux de changement de température de la seule cellule de batterie dans le jeu de batteries et la température maximale de la seule cellule de batterie dans le jeu de batteries,
le taux de changement de température de la seule cellule de batterie dans le jeu de batteries et la différence entre la température maximale et la température minimale de la seule cellule de batterie dans le jeu de batteries,
le nombre de défauts de déconnexion de l'échantillonnage de tension du jeu de batteries et la température maximale de la seule cellule de batterie dans le jeu de batteries,
le nombre de défauts de déconnexion de l'échantillonnage de tension du jeu de batteries et le taux de changement de température de la seule cellule de batterie dans le jeu de batteries,
le nombre de défauts de déconnexion de l'échantillonnage de tension du jeu de batteries et la différence entre la température maximale et la température minimale de la seule cellule de batterie dans le jeu de batteries,
le nombre de défauts de déconnexion de l'échantillonnage de tension du jeu de batteries et un paramètre de défaut d'induction de température,
dans lequel la condition de défaut comprend : un paramètre dépasse une plage de seuils de sécurité du paramètre, ou un paramètre indique un défaut.
